# EUROPEAN PATENT SPECIFICATION

(11) **EP 4 336 809 B1**
(45) Date of publication and mention of the grant of the patent: **18.03.2026**
(21) Application number: 23751839.4
(22) Date of filing: 26.07.2023
(51) Int. Cl.: H04M 1/02, H05K 1/14, G06F 1/16

(54) **FOLDABLE ELECTRONIC DEVICE COMPRISING FLEXIBLE PRINTED CIRCUIT BOARD**
FALTBARE ELEKTRONISCHE VORRICHTUNG MIT FLEXIBLER LEITERPLATTE
DISPOSITIF ÉLECTRONIQUE PLIABLE COMPRENANT UNE CARTE DE CIRCUIT IMPRIMÉ SOUPLE

(30) Priority: 26.07.2022 KR 20220092631; 09.08.2022 KR 20220099527
(43) Date of publication of application: 13.03.2024
(73) Proprietor: Samsung Electronics Co., Ltd., Suwon-si, Gyeonggi-do 16677 (KR)
(72) Inventor: PARK, Honjeong, Suwon-si, Gyeonggi-do 16677 (KR); KWON, Kihwan, Suwon-si, Gyeonggi-do 16677 (KR); LEE, Hyunggeun, Suwon-si, Gyeonggi-do 16677 (KR); JUNG, Youngjin, Suwon-si, Gyeonggi-do 16677 (KR)
(74) Representative: Gulde & Partner
(86) International application number: PCT/KR2023/010841
(87) International publication number: WO 2024/025341

(56) References cited:
- KR-A- 20190 137 433
- KR-A- 20200 021 172
- KR-A- 20210 101 669
- KR-B1- 101 670 890
- US-A1- 2013 050 961
- US-A1- 2021 247 806
- US-B1- 10 469 635

## Description

### [Technical Field]

The disclosure relates to a foldable electronic device including a flexible printed circuit board.

### [Background Art]

A foldable electronic device has a screen (or display) that is capable of being folded. The US 2021/247806 A1 discloses a foldable electronic device with a first housing and a second housing, wherein the foldable electronic device includes a flexible connection member being a flexible printed circuit board extending across a hinged structure. The flexible connection member includes, along the longitudinal direction of the flexible connection member, rigid portions for connection with both sides of the housing and with a flex portion therebetween. The US 2013/050961 A1 discloses a device with flexible printed circuit board including a first case and a second case, an elastic portion, a groove and an adhesive layer fixing the first case with the second case.

The aforementioned information may be provided as the related art for the purpose of enhancing the understanding of the disclosure. No argument or decision is raised about whether the above-mentioned contents can be applied to the prior art related to the disclosure.

### [Disclosure of Invention]

### [Technical Problem]

A foldable electronic device may include a flexible printed circuit board (FPCB) disposed in an inner space of the foldable electronic device across a folding portion. Due to assembly deviation (or assembly position deviation), e.g., a degree of deviation or inaccuracy in numerical value, position, or orientation when assembled, structures including the flexible printed circuit board and other constituent elements connected, coupled, or fixed to the flexible printed circuit board may be difficult to be reliably positioned.

Example embodiments of the disclosure may provide a foldable electronic device including a flexible printed circuit board which is capable of stably positioning a structure including a flexible printed circuit board and other constituent elements connected, coupled, or fixed to the flexible printed circuit board.

### [Solution to Problem]

Technical problems to be solved by the disclosure are not limited to the above-mentioned technical problems, and other technical problems, which are not mentioned above, may be understood from the following descriptions by those skilled in the art to which the disclosure pertains.

According to the invention, a foldable electronic device is provided according to claim 1 of the appended set of claims.

### [Advantageous Effects of Invention]

Since the foldable electronic device including the flexible printed circuit board, according to example embodiments of the disclosure stably dispose a structure including a flexible printed circuit board and/or other constituent elements connected, coupled, or fixed to the flexible printed circuit board, yield and reliability for the foldable electronic device may be improved.

Other effects, which may be obtained or expected by the various embodiments of the disclosure, will be directly or implicitly disclosed in the detailed description on the embodiments of the disclosure.

### [Brief Description of Drawings]

The above and other aspects, features, and advantages of specific embodiments of the disclosure will become clearer from the following detailed description, which is provided together with the accompanying drawings.
FIG. 1 is a block diagram of an electronic device in a network environment according to an embodiment of the disclosure.
FIG. 2 are views illustrating a foldable electronic device in an unfolded state, according to an embodiment of the disclosure.
FIG. 3 is a view illustrating the foldable electronic device in a folded state according to an embodiment of the disclosure.
FIG. 4 is an exploded perspective view of the foldable electronic device in an unfolded state according to an embodiment of the disclosure.
FIG. 5 is a view illustrating a portion of the foldable electronic device in an unfolded state according to an embodiment of the disclosure.
FIG. 6 is a cross-sectional view illustrating a portion of the foldable electronic device that is cut along lines C-C' in FIG. 5 according to an embodiment of the disclosure.
FIG. 7 is a view illustrating a process of disposing a first flexible printed circuit board, according to an embodiment of the disclosure.
FIGS. 8 and 9 are exploded perspective views of the foldable electronic device according to an embodiment of the disclosure.
FIG. 10 is a perspective view of the foldable electronic device in an unfolded state according to an embodiment of the disclosure.
FIG. 11 is a view illustrating the foldable electronic device in an unfolded state according to an embodiment of the disclosure.
FIG. 12 is a view illustrating the foldable electronic device in the unfolded state according to an embodiment of the disclosure.
FIG. 13 is a view illustrating the foldable electronic device that a connection member is separated.

### [Mode for the Invention]

Hereinafter, various example embodiments of the disclosure disclosed herein will be described in greater detail with reference to the accompanying drawings.

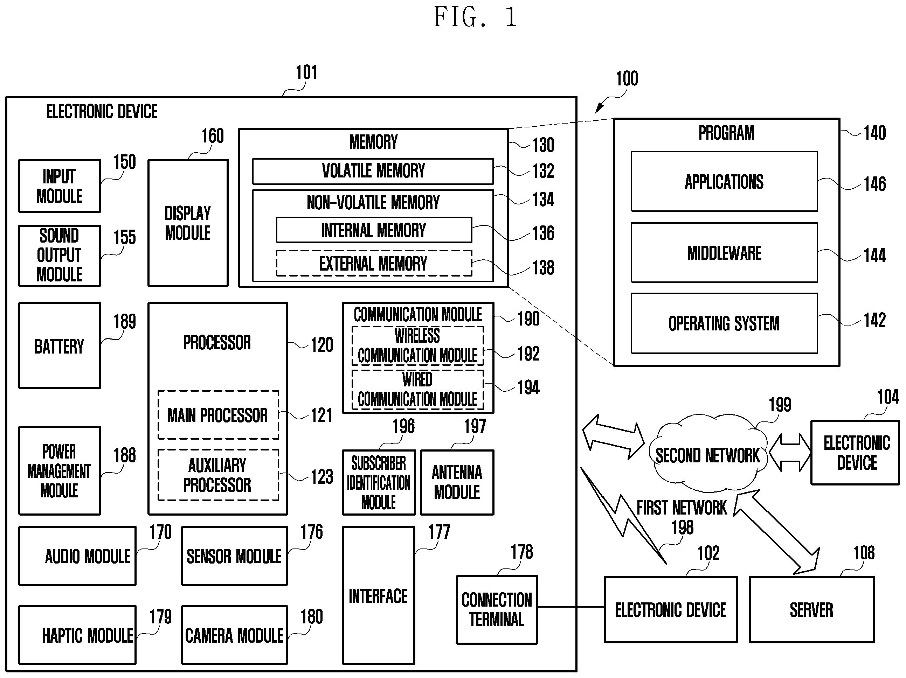

FIG. 1 is a block diagram of an electronic device 101 in a network environment 100 according to an embodiment of the disclosure.

Referring to FIG. 1, the electronic device 101 in the network environment 100 may communicate with an external electronic device 102 via a first network 198 (e.g., a short-range wireless communication network), or at least one of an external electronic device 104 or a server 108 via a second network 199 (e.g., a long-range wireless communication network). The electronic device 101 may communicate with the external electronic device 104 via the server 108. The electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, and/or an antenna module 197. In some embodiments of the disclosure, at least one (e.g., the connection terminal 178) of the components may be omitted from the electronic device 101, or one or more other components may be added in the electronic device 101. In some embodiments of the disclosure, some of the components may be implemented as single integrated circuitry. For example, the sensor module 176, the camera module 180, or the antenna module 197 may be implemented as embedded in single component (e.g., the display module 160).

The processor 120 may execute, for example, software (e.g., a program 140) to control at least one other component (e.g., a hardware or software component) of the electronic device 101 coupled with the processor 120, and may perform various data processing or computation. As at least part of the data processing or computation, the processor 120 may load a command or data received from another component (e.g., the sensor module 176 or the communication module 190) in a volatile memory 132, process the command or the data stored in the volatile memory 132, and store resulting data in a non-volatile memory 134. The processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., a sleep) state, or together with the main processor 121 while the main processor 121 is in an active state (e.g., executing an application). The auxiliary processor 123 (e.g., an ISP or a CP) may be implemented as part of another component (e.g., the camera module 180 or the communication module 190) functionally related to the auxiliary processor 123. According to an embodiment of the disclosure, the auxiliary processor 123 (e.g., a neural network processing device) may include a hardware structure specified for processing an artificial intelligence model. The artificial intelligence model may be created through machine learning. Such learning may be performed, for example, in the electronic device 101 itself on which the artificial intelligence model is performed, or may be performed through a separate server (e.g., the server 108). The learning algorithms may include, for example, supervised learning, unsupervised learning, semi-supervised learning, or reinforcement learning, but is not limited thereto. The artificial intelligence model may include a plurality of artificial neural network layers. The artificial neural network may be any of a deep neural network (DNN), a convolutional neural network (CNN), a recurrent neural network (RNN), a restricted Boltzmann machine (RBM), a deep belief network (DBN), a bidirectional recurrent DNN (BRDNN), a deep Q-network, or a combination of two or more of the above-mentioned networks, but is not limited the above-mentioned examples. In addition to the hardware structure, the artificial intelligence model may additionally or alternatively include a software structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 and/or the non-volatile memory 134.

The program 140 may be stored in the memory 130 as software, and may include, for example, an operating system (OS) 142, middleware 144, and/or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record, and the receiver may be used for incoming calls. The receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. The display module 160 may include touch circuitry (e.g., a touch sensor) adapted to detect a touch, or sensor circuitry (e.g., a pressure sensor) adapted to measure the intensity of force incurred by the touch.

The audio module 170 may convert a sound into an electrical signal and vice versa. The audio module 170 may obtain the sound via the input module 150, or output the sound via the sound output module 155 or a headphone of an external electronic device (e.g., the external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. The interface 177 may include, for example, a high-definition multimedia interface (HDMI), a universal serial bus (USB) interface, a secure digital (SD) card interface, and/or an audio interface.

The connecting terminal 178 may include a connector via which the electronic device 101 may be physically connected with the external electronic device (e.g., the external electronic device 102). The connecting terminal 178 may include, for example, an HDMI connector, a USB connector, an SD card connector, and/or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image or moving images. The camera module 180 may include one or more lenses, image sensors, ISPs, or flashes.

The power management module 188 may manage power supplied to or consumed by the electronic device 101. The power management module 188 may be implemented as at least part of, for example, a power management integrated circuit (PMIC).

The battery 189 may supply power to at least one component of the electronic device 101. The battery 189 may include, for example, a primary cell which is not rechargeable, a secondary cell which is rechargeable, and/or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more CPs that are operable independently from the processor 120 (e.g., the AP) and supports a direct (e.g., wired) communication or a wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BLUETOOTH, wireless-fidelity (Wi-Fi) direct, or IR data association (IrDA)) or the second network 199 (e.g., a long-range communication network, such as a legacy cellular network, a 5^{th} generation (5G) network, a next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4^{th} generation (4G) network, and next-generation communication technology, e.g., new radio (NR) access technology. The NR access technology may support high-speed transmission of high-capacity data (i.e., enhanced mobile broadband (eMBB)), minimization of terminal power and connection of multiple terminals (massive machine type communications (mMTC)), or high reliability and low latency (ultra-reliable and low-latency communications (URLLC)). The wireless communication module 192 may support a high-frequency band (e.g., a mmWave band) to achieve, for example, a high data transmission rate. The wireless communication module 192 may support various technologies for securing performance in a high-frequency band, such as beamforming, massive multiple-input and multiple-output (MIMO), full-dimensional MIMO (FD-MIMO), array antenna, analog beam-forming, or large-scale antenna. The wireless communication module 192 may support various requirements specified in the electronic device 101, an external electronic device (e.g., external the electronic device 104), or a network system (e.g., the second network 199). According to an embodiment of the disclosure, the wireless communication module 192 may support a peak data rate for implementing eMBB (e.g., 20Gbps or more), loss coverage for implementing mMTC (e.g., 164dB or less), or U-plane latency for realizing URLLC (e.g., 0.5ms or less for each of downlink (DL) and uplink (UL) or 1ms or less for round trip).

The antenna module 197 may transmit or receive a signal or power to or from the outside (e.g., the external electronic device) of the electronic device 101. The antenna module 197 may include an antenna including a radiating element including a conductive material or a conductive pattern formed in or on a substrate (e.g., a printed circuit board (PCB)). The antenna module 197 may include a plurality of antennas (e.g., an antenna array). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. Another component (e.g., a radio frequency integrated circuit (RFIC)) other than the radiating element may be additionally formed as part of the antenna module 197.

According to various embodiments of the disclosure, the antenna module 197 may form a mmWave antenna module. According to an embodiment of the disclosure, the mmWave antenna module may include a PCB, an RFIC that is disposed on or adjacent to a first surface (e.g., the bottom surface) of the PCB and is capable of supporting a predetermined high-frequency band (e.g., a mmWave band), and a plurality of antennas (e.g., array antennas) that is disposed on or adjacent to a second surface (e.g., the top surface or the side surface) of the PCB and is capable of transmitting or receiving a signal of the predetermined high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

Commands or data may be transmitted or received between the electronic device 101 and the external electronic device 104 via the server 108 coupled with the second network 199. Each of the external electronic devices 102 or 104 may be a device of a same type as, or a different type, from the electronic device 101. All or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide an ultra-low delay service using, for example, distributed computing or MEC. In another embodiment of the disclosure, the external electronic device 104 may include an internet of things (IoT) device. The server 108 may be an intelligent server using machine learning and/or neural networks. According to an embodiment of the disclosure, the external electronic device 104 or the server 108 may be included in the second network 199. The electronic device 101 may be applied to an intelligent service (e.g., smart home, smart city, smart car, or healthcare) based on 5G communication technology or IoT-related technology.

An electronic device according to an embodiment of the disclosure may be one of various types of electronic devices. The electronic devices may include a portable communication device (e.g., a smartphone), a computer device, a portable multimedia device, a portable medical device, a camera, a wearable device, or a home appliance. However, the electronic device is not limited to any of those described above.

Various embodiments of the disclosure and the terms used herein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). If an element (e.g., a first element) is referred to, with or without the term "operatively" or "communicatively," as "coupled with," "coupled to," "connected with," or "connected to" another element (e.g., a second element), the element may be coupled with the other element directly (e.g., wiredly), wirelessly, or via a third element.

The term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment of the disclosure, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

A method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PLAYSTORE^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

Each component (e.g., a module or a program) of the above-described components may include a single entity or multiple entities. One or more of the above-described components may be omitted, or one or more other components may be added. Alternatively or additionally, a plurality of components (e.g., modules or programs) may be integrated into a single component. In such a case, the integrated component may perform one or more functions of each of the plurality of components in the same or similar manner as they are performed by a corresponding one of the plurality of components before the integration. Operations performed by the module, the program, or another component may be carried out sequentially, in parallel, repeatedly, or heuristically, or one or more of the operations may be executed in a different order or omitted, or one or more other operations may be added.

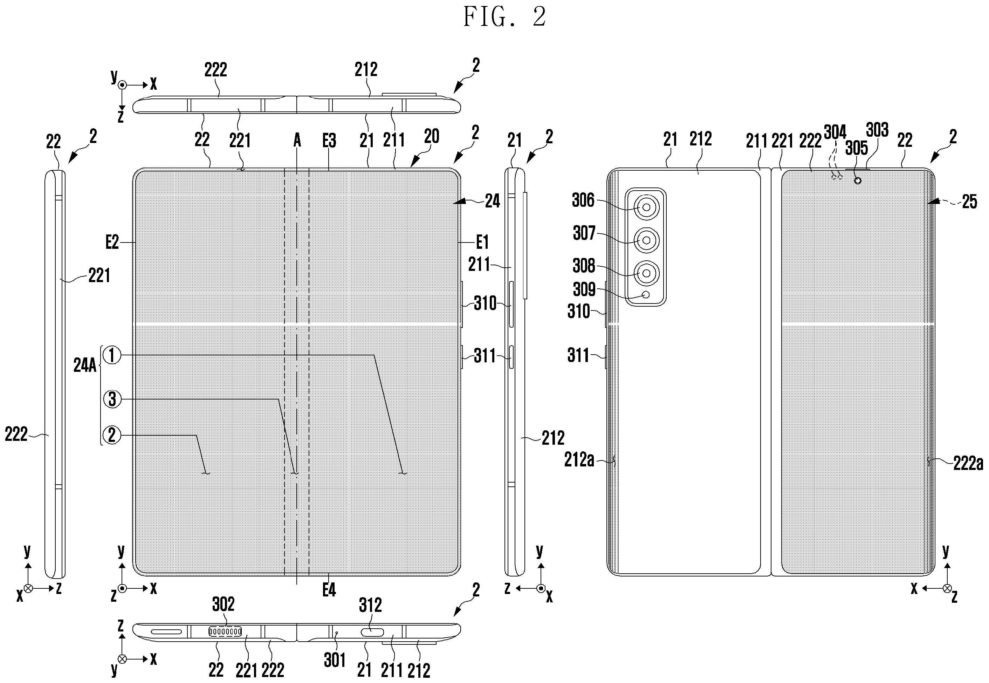

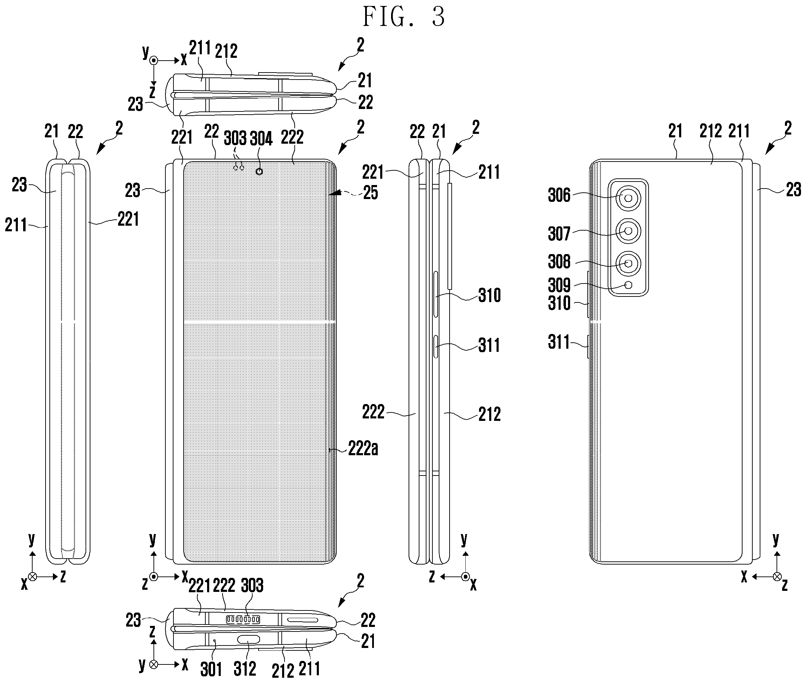

FIG. 2 is a view illustrating a foldable electronic device 2 in an unfolded state (or unfolding state, or flat state) according to an embodiment of the disclosure. FIG. 3 is a view illustrating the foldable electronic device 2 in a folded state (or folding state) according to an embodiment of the disclosure.

With reference to FIGS. 2 and 3, the foldable electronic device 2 includes a foldable housing 20 Further, the foldable electronic device 2 may include a first display module (e.g., a flexible display module or a foldable display module) 24, and/or a second display module 25. In various embodiments, the foldable electronic device 2 may be the electronic device 101 in FIG. 1.

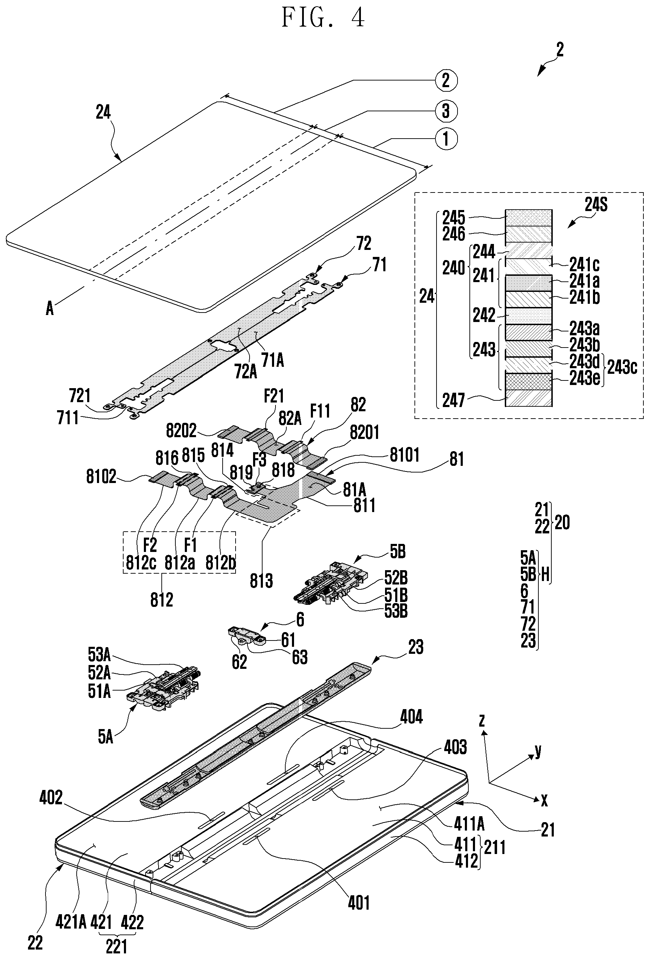

The foldable housing 20 includes a first housing (or a first housing portion or a first housing structure) 21, a second housing (or a second housing portion or a second housing structure) 22 and a hinge portion. Further, according to an embodiment, the foldable housing 20 may include a hinge housing 23. The first housing 21 and the second housing 22 are connected by means of a hinge portion and are mutually rotatable relative to the hinge portion. The hinge portion may include one or more hinge modules (or hinge assemblies), e.g., a first hinge module 5A and/or a second hinge module 5B in FIG. 4.

According to an embodiment, a display area 24A of the first display module 24 is an active area of the first display module 24 capable of displaying an image, and may include a first display area (or a first active area or a first screen area) ①, a second display area (or a second active area or a second screen area) ②, and a third display area (or a third active area or a third screen area) ③ that connects the first display area ① and the second display area ②. The first display area ① may be positioned corresponding to the first housing 21. The second display area ② may be positioned corresponding to the second housing 22. The third display area ③ may be positioned corresponding to the hinge portion. The first display area ① is disposed in the first housing 21, and the shape of the first display area ① may be maintained by the support of the first housing 21. The second display area ② is disposed in the second housing 22, and the shape of the second display area ② may be maintained by the support of the second housing 22. The first display area ① and the second display area ② may be provided, for example, substantially flat. The unfolded state of the foldable electronic device 2 (see FIG. 2) may be a state in which the third display area ③ is disposed substantially flat. In the unfolded state of the foldable electronic device 2, the first display area ① and the second display area ② may form an angle of approximately 180 degrees, and the display area 24A including the first display area ①, the second display area ②, and the third display area ③ may be provided (or disposed) in a substantially planar form. The third display area ③, which connects the first display area ① and the second display area ②, may be disposed flat because of the relative position between the first display area ① disposed in the first housing 21 and the second display area ② disposed in the second housing 22 in the unfolded state of the foldable electronic device 2. In the unfolded state of the foldable electronic device 2, the third display area ③ may be pulled from both sides by the first display area ① and the second display area ②, and the pulling force may be provided to dispose the third display area ③ flat and reduce breakage of the third display area ③. In the unfolded state of the foldable electronic device ②, the third display area ③ may be pulled by the first display area ① and the second display area ② and provided to have an increased width that allows the third display area ③ to be disposed flat with reduced stress. In the unfolded state of the foldable electronic device 2, the hinge portion may support the third display area ③. In the unfolded state of the foldable electronic device 2, in case that an external force (e.g., an external pressure such as a touch input using a user's finger or a touch input using an electronic pen) is applied to the third display area ③, the hinge portion may contribute to reducing a sagging phenomenon of the third display area ③ so that the third display area ③ remains flat. In the unfolded state of the foldable electronic device 2, in case that an external impact such as a fall is applied, the hinge portion may be constituted to reduce the influence of the external impact on the third display area ③. In the unfolded state of the foldable electronic device 2, the hinge portion supports the third display area ③ so that the third display area ③ may be disposed flat without sagging, thereby reducing a crease phenomenon. The illustrated coordinate axes are illustrated with respect to the first housing 21. For example, the +z axis direction may be interpreted as a direction in which the plane provided by the flat first display area ① is oriented.

According to an embodiment, the foldable electronic device 2 may be provided in an infolding manner in which the display area 24A of the first display module 24 is folded inward. FIG. 3 illustrates a fully folded state of the foldable electronic device 2, in which the first housing 21 and the second housing 22 are disposed so that the first housing is no longer close to the second housing. In the fully folded state of the foldable electronic device 2, the first display area ① and the second display area ② may be disposed facing each other, and the third display area ③ may be disposed in the form of being bent. In the fully folded state of the foldable electronic device 2, an angle between the first housing 21 and the second housing 22 (or an angle between the first display area ① and the second display area ②) may be from approximately 0 degrees to approximately 10 degrees, and the display area 24A may be substantially invisible. Although not illustrated, an intermediate state of the foldable electronic device 2 may be a state between an unfolded state and a fully folded state, or a less folded state compared to a fully folded state. In case of the intermediate state in which the angle between the first housing 21 and the second housing 22 is equal to or greater than any angle, a usage environment in which there is no substantial difficulty for a user to use the display area 24A may be provided. Hereinafter, a folded state of the foldable electronic device 2 as described in the disclosure may refer to a fully folded state compared to an intermediate state of a less folded state.

According to an embodiment, with reference to the unfolded state of the foldable electronic device 2 (see FIG. 2), the display area 24A of the first display module 24 may be provided in a symmetrical form with respect to the center line A of the foldable electronic device 2. With reference to the unfolded state of the foldable electronic device 2, the center line A may correspond to the middle of a width extending from a first boundary between the first display area ① and the third display area ③ to a second boundary between the second display area ② and the third display area ③. In various embodiments, the center line A of the foldable electronic device 2 may be "a folding axis" of the foldable housing 20 or the foldable electronic device 2. The folding axis may be provided (or formed) by the hinge portion.

According to an embodiment, in the folded state of the foldable electronic device 2 (see FIG. 3), the third display area ③ disposed in the form of being bent may have a substantially symmetrical shape with respect to the center line A of the foldable electronic device 2. With reference to the unfolded state of the foldable electronic device 2, the display area 24A may be substantially rectangular. The display area 24A may include a first edge E1, a second edge E2, a third edge E3, and a fourth edge E4. The first edge E1 and the second edge E2 may be substantially parallel to the center line A. The third edge E3 may connect one end of the first edge E1 and one end of the second edge E2, and the fourth edge E4 may connect the other end of the first edge E1 and the other end of the second edge E2. The first display area ① may include the first edge E1, a portion of the third edge E3, and a portion of the fourth edge E4. The second display area ② may include the second edge E2, a portion of the third edge E3, and a portion of the fourth edge E4. The third display area ③ may include a portion of the third edge E3 and a portion of the fourth edge E4. In the folded state of the foldable electronic device 2, the first edge E1 and the second edge E2 may be overlapped to be aligned. In the folded state of the foldable electronic device 2, a portion of the third edge E3 included in the first display area ① and a portion of the third edge E3 included in the second display area ② may be overlapped to be aligned. In the folded state of the foldable electronic device 2, a portion of the fourth edge E4 included in the first display area ① and a portion of the fourth edge E4 included in the second display area ② may be overlapped to be aligned.

According to an embodiment, the first housing 21 may include a first frame (or a first frame structure or a first framework) 211 and/or a first cover 212 disposed on the first frame 211. The first frame 211 may include a first side (or a first side surface portion, a first lateral member, a first side surface structure, or a first side surface bezel structure) (e.g., the first side 412 in FIG. 4). The first side may be disposed along an edge of the first display area ① of the first display module 24. The first side may provide a first side surface of the foldable electronic device 2 corresponding to the first display area ① of the foldable electronic device 2. The first frame 211 may include a first support portion (e.g., a first support portion 411 in FIG. 4) extending from or connected to the first side. The first display area ① may be disposed on the first support portion, and the first support portion may support the first display area ①. The first display area ① and the first cover 212 may be positioned opposite to each other with a first support portion of the first frame 211 interposed therebetween. The first side of the first frame 211 may be disposed to at least partially enclose a space between the first display area ① and the first cover 212. The first display area ① may provide one surface of an outer surface of the foldable electronic device 2, and the first cover 212 may provide the other surface of the outer surface of the foldable electronic device 2 that is directed in a direction substantially opposite to the first display area ①. Various electrical components (or electronic components or elements), such as printed circuit boards or batteries, may be disposed on the first support portion between the first support portion of the first frame 211 and the first cover 212.

According to an embodiment, the second housing 22 may include a second frame (or a second frame structure or a second framework) 221 and/or a second cover 222 disposed on the second frame 221. The second frame 221 may include a second side (or a second side surface portion, a second lateral member, a second side surface structure, or a second side surface bezel structure) (e.g., a second side 422 in FIG. 4). The second side may be disposed along an edge of the second display area ② of the first display module 24. The second side may provide a second side surface of the foldable electronic device 2 corresponding to the second display area ② of the foldable electronic device 2. In the folded state of the foldable electronic device 2 (see FIG. 3), the first side of the first frame 211 and the second side of the second frame 221 may be overlapped to be aligned. The second frame 221 may include a second support portion extending from or connected to the second side (e.g., a second support portion 421 in FIG. 4). The second display area ② may be disposed on the second support portion, and the second support portion may support the second display area ②. The second display area ② and the second cover 222 may be positioned opposite to each other with the first support portion of the second frame 221 interposed therebetween. The second side of the second frame 221 may be disposed to at least partially enclose a space between the second display area ② and the second cover 222. The second display area ② may provide one surface of an outer surface of the foldable electronic device 2, and the second cover 222 may provide the other surface of the outer surface of the foldable electronic device 2 that is directed in a direction substantially opposite to the second display area ②. Various electrical constituent elements (or electronic components or elements), such as a printed circuit board or a battery, may be disposed on the second support portion between the second support portion of the second frame 221 and the second cover 222.

According to an embodiment, the hinge housing (or a hinge cover) 23 may be coupled with the first hinge module 5A, the second hinge module 5B, and/or a guide rail assembly 6. When the foldable electronic device 2 transitions from the unfolded state (see FIG. 2) to the folded state (see FIG. 3), a gap between the first housing 21 and the second housing 22 may be opened on the opposite side of the third display area ③, and the hinge housing 23 may be exposed to the outside through the opened gap, because of a change in the relative position between the first housing 21 and the second housing 22, which are connected to each other by means of the hinge portion and because of a change in the state of the hinge portion coupled to the hinge housing 23. In the folded state of the foldable electronic device 2, the hinged housing 23 may be a portion of the external appearance that conceals the inside of the foldable electronic device 2 through the opened gap between the first housing 21 and the second housing 22. The hinge housing 23 may be more exposed in the folded state of FIG. 3 than in the intermediate state. When the foldable electronic device 2 transitions from the folded state to the unfolded state, the gap between the first housing 21 and the second housing 22 on the opposite side of the third display area ③ is closed, and the hinge housing 23 may be positioned in an inner space caused by the combination of the first housing 21 and the second housing 22 and may not be exposed to the outside, because of a change in the relative position between the first housing 21 and the second housing 22 connected to each other by means of the hinge portion, and because of a change in the state of the hinge portion coupled with the hinge housing 23, .

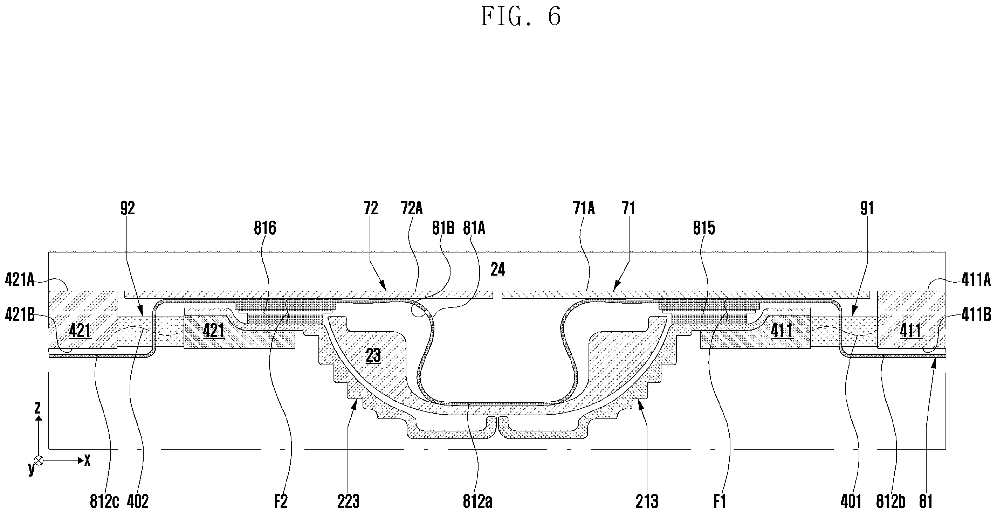

According to an embodiment, the first housing 21 may include a first hinge housing cover 213 (see FIG. 6) coupled to the first support portion 411 of the first frame 211. The second housing 22 may include a second hinge housing cover 223 (see FIG. 6) coupled to the second support portion 421 of the second frame 221. In the unfolded state of the foldable electronic device 2, the first hinge housing cover 213 and the second hinge housing cover 223 may each cover both sides of the hinge housing 23, and the hinge housing 23 may not be exposed to the outside. In the folded state of the foldable electronic device 2, the hinge housing 23 may be exposed to the outside through the first hinge housing cover 213 and the second hinge housing cover 223 to provide a portion of the external appearance of the foldable electronic device 2. In the folded state of the foldable electronic device 2, one surface exposed to the outside of the hinge housing 23 may include a curved surface, and the first hinge housing cover 213 and the second hinge housing cover 223 may be provided with a curved shape including a curved surface portion corresponding to the curved surface. In various embodiments, the first frame 211 (or first support portion 411) may be provided in the form of further including a portion corresponding to the first hinge housing cover 213. In this case, the first hinge housing cover 213 may be omitted. In various embodiments, the second frame 221 (or the second support portion 421) may be provided in the form of further including a portion corresponding to the second hinge housing cover 223. In this case, the second hinge housing cover 223 may be omitted.

According to an embodiment, the second display module 25 may be positioned between the second frame 221 and the second cover 222. The second cover 222 may be substantially transparent, and the second display module 25 may be visible through the second cover 222. In the folded state, the foldable electronic device 2 may be constituted to display an image through the second display module 25 in place of the first display module 24.

According to an embodiment, the first cover 212 may include a first curved surface area 212a that curves and seamlessly extends toward the first display area ① corresponding to the first edge E1 of the display area 24A. The second cover 222 may include a second curved surface area 222a that curves and seamlessly extends toward the second display area ② corresponding to the second edge E2 of the display area 24A. The first curved surface area 212a and the second curved surface area 222a may be provided symmetrically to each other on opposite sides of the foldable electronic device 2 in the unfolded state (see FIG. 2) or the folded state (see FIG. 3), thereby contributing to an aesthetic external appearance. In an embodiment, the second display module 25 may include a flexible display that may be disposed corresponding to the second curved surface area 222a. In various embodiments, the first cover 212 may be provided substantially flat without the first curved surface area 212a. In various embodiments, the second cover 222 may be provided substantially flat without the second curved surface area 222a. In this case, the second display module 25 may include a rigid display.

According to an embodiment, the foldable electronic device 2 may include one or more audio modules (e.g., the audio module 170 in FIG. 1), one or more sensor modules (e.g., the sensor module 176 in FIG. 1), one or more camera modules (e.g., the camera module 180 in FIG. 1), one or more light emitting modules, one or more input modules (e.g., the input module 150 in FIG. 1), and/or one or more connection terminal modules (e.g., the interface 177 or the connection terminal 178 in FIG. 1). In various embodiments, the foldable electronic device 2 may omit at least one of the constituent elements or may additionally include other constituent elements. The position or number of constituent elements included in the foldable electronic device 2 may vary without being limited to the examples illustrated.

Any one of the one or more audio modules may include, for example, a microphone positioned inside the foldable electronic device 2 corresponding to a microphone hole 301 provided in the external appearance of the foldable electronic device 2. In the example illustrated, the microphone hole 301 may be provided on the first side of the first frame 211, and the microphone may be positioned in an inner space of the first housing 21. The position or number of microphones and microphone holes may vary and are not limited to the examples illustrated. In various embodiments, the foldable electronic device 2 may include a plurality of microphones utilized to detect a direction of sound.

Any one of the one or more audio modules may include, for example, a first speaker for multimedia playback (or for recording playback) positioned inside the foldable electronic device 2, corresponding to a first speaker hole 302 provided on the external appearance of the foldable electronic device 2. In the example illustrated, the first speaker hole 302 may be provided on the second side of the second frame 221, and the first speaker may be positioned in an inner space of the second housing 22. Any one of the one or more audio modules may include, for example, a second speaker for calls (e.g., a receiver for calls) positioned inside the foldable electronic device 2 corresponding to a second speaker hole (e.g., a receiver hole) 303 provided on the external appearance of the foldable electronic device 2. In the example illustrated, the second speaker hole 303 may be adjacent to the second cover 222 and provided in the second frame 221, and the second speaker may be positioned in the inner space of the second housing 22. The position or number of speakers and speaker holes may vary and are not limited to the examples illustrated. In various embodiments, the microphone hole and the speaker hole may be implemented in a single hole. In various embodiments, a piezo speaker may be provided in which the speaker hole is omitted.

The one or more sensor modules may, for example, generate electrical signals or data values corresponding to an internal operational state of the foldable electronic device 2, or an external environmental state. In an embodiment, any one of the one or more sensor modules may include an optical sensor 304 positioned in the interior space of the second housing 22 corresponding to the second cover 222. The optical sensor 304 may be positioned in alignment with an opening provided in the second display module 25 or inserted at least partially into the opening. External light may reach the optical sensor through openings provided in the second cover 222, and the second display module 25. The optical sensor 304 may include, for example, a proximity sensor or an illumination sensor. The number or position of optical sensors may vary and are not limited to the examples illustrated.

According to various embodiments, the optical sensor 304 may be overlapped with at least a portion of a display area of the second display module 25 and positioned in an inner space of the second housing 22, when viewed from the top of the second cover 222. In this case, the optical sensor 304 or the position of the optical sensor 304 may not be visually distinguishable (or exposed) or visible, but the sensing function of the optical sensor 304 may be performed. In an embodiment, the optical sensor 304 may be positioned on the back surface of the second display module 25 or below or beneath the second display module 25, and the optical sensor 304 or the position of the optical sensor 304 may not be visually distinguishable (or exposed). In various embodiments, the optical sensor 304 may be positioned in alignment with, or at least partially inserted into, a recess provided in the back surface of the second display module 25. Some areas of the second display module 25 that are at least partially overlapped with the optical sensor 304 may include different pixel structure and/or wiring structure than other areas. For example, some areas of the second display module 25 that are at least partially overlapped with the optical sensor 304 may have a different pixel density than other areas. The pixel structure and/or wiring structure formed in some area of the second display module 25 that is at least partially overlapped with the optical sensor 304 may reduce the loss of light between the outside and the optical sensor 304. In another example, a plurality of pixels may not be disposed in some areas of the second display module 25 that are at least partially overlapped with the optical sensor 304.

According to various embodiments, the optical sensor 304 is not limited to a proximity sensor or a illumination sensor, but various other sensors may be positioned corresponding to the opening provided in the second display module 25, or may be positioned on the back surface of the second display module 25, or below or beneath the second display module 25. For example, an optical, capacitive, or ultrasonic biometric sensor (e.g., a fingerprint sensor) may be positioned corresponding to the opening provided in the second display module 25 or positioned on the back surface of the second display module 25 or below or beneath the second display module 25.

According to various embodiments, various sensors may be positioned corresponding to an opening provided in the first display module 24 or positioned on the back surface of the first display module 24, or below or beneath the first display module 24.

According to various embodiments, the foldable electronic device 2 may include various other sensors (e.g., a gesture sensor, a gyro sensor, a barometric pressure sensor, a magnetic sensor, an acceleration sensor, a grip sensor, a color sensor, an infrared (IR) sensor, a temperature sensor, or a humidity sensor), the positions of which may vary.

According to an embodiment, the one or more camera modules may include one or a plurality of lenses, an image sensor, and/or an image signal processor. The one or more camera modules may include, for example, a first camera module 305, a second camera module 306, a third camera module 307, and/or a fourth camera module 308.

According to an embodiment, the first camera module 305 may be positioned in an inner space of the second housing 22 corresponding to the second cover 222. The first camera module 305 may be positioned in alignment with the opening provided in the second display module 25 or at least partially inserted into the opening. External light may reach the first camera module 305 through the opening in the second cover 222 and the second display module 25. The opening in the second display module 25 aligned or overlapped with the first camera module 305 may be provided in the form of a through hole, as in the example illustrated. In various embodiments, the opening of the second display module 25 aligned or overlapped with the first camera module 305 may be provided in the form of a notch.

According to various embodiments, when viewed from the top of the second cover 222, the first camera module 305 may be overlapped with at least some of the display area of the second display module 25 and positioned in the inner space of the second housing 22. In this case, the first camera module 305 or the position of the first camera module 305 may not be visually distinguished (or exposed) or visual, and the shooting function of the first camera module 305 may be performed. In an embodiment, the first camera module 305 may be positioned on the back surface of the second display module 25 or below or beneath the second display module 25, and the first camera module 305 or the position of the first camera module 305 may not be visually distinguishable (or exposed) or visible. In various embodiments, the first camera module 305 may be positioned in alignment with, or at least partially inserted into, a recess provided in the back surface of the second display module 25. The first camera module 305 may include, for example, a concealed display back surface camera (e.g., an under display camera (UDC)). Some areas of the second display module 25 that are at least partially overlapped with the first camera module 305 may include a different pixel structure and/or wiring structure than other areas. For example, some areas of the second display module 25 that are at least partially overlapped with the first camera module 305 may have a different pixel density than other areas. The pixel structure and/or wiring structure formed in some area of the second display module 25 that is at least partially overlapped with the first camera module 305 may reduce the loss of light between the outside and the optical sensor. In another example, a plurality of pixels may not be disposed in some areas of the second display module 25 that are at least partially overlapped with the first camera module 305.

According to an embodiment, the second camera module 306, the third camera module 307, or the fourth camera module 308 may be positioned in an inner space of the first housing 21 corresponding to the first cover 212. The first cover 212 may include a camera cover portion (e.g., a camera decorative portion) disposed corresponding to the second camera module 306, the third camera module 307, and the fourth camera module 308. The camera cover portion may include a camera hole (or light transmission area) provided corresponding to the second camera module 306, a camera hole (or light transmission area) provided corresponding to the third camera module 307, and a camera hole (or light transmission area) provided corresponding to the fourth camera module 308. The number or position of camera modules provided corresponding to the first cover 212 may vary, without being limited to the example illustrated. The second camera module 306, the third camera module 307, and the fourth camera module 308 may have different properties (e.g., angle of view) or functions. The second camera module 306, third camera module 307, and fourth camera module 308 may provide different angles of view (or lenses with different angles of view), and the foldable electronic device 2 may selectively use the corresponding camera module on the basis of a user's choice with respect to the angle of view. Any of the second camera module 306, the third camera module 307, and the fourth camera module 308 may include a wide angle camera module, a telephoto camera module, a color camera module, a monochrome camera module, or an infrared (IR) camera (e.g., time of flight (TOF) camera, structured light camera) module. **In** various embodiments, the IR camera module may operate as at least a portion of the sensor module.

According to an embodiment, any one of the one or more light emitting modules may include a flash 309 positioned in the inner space of the first housing 21 corresponding to a flash hole (or light transmission area) provided in the camera cover portion of the first cover 212. The flash 309 may include a light source for the second camera module 306, the third camera module 307, and/or the fourth camera module 308. The flash 309 may include, for example, a light emitting diode (LED) or a xenon lamp.

According to various embodiments, any one of the one or more light emitting modules (e.g., LED, IR LED, or xenon lamp) may be constituted to provide state information on the foldable electronic device 2 in the form of light. In various embodiments, the light emitting module may provide a light source that is in conjunction with an operation of the first camera module 305.

According to an embodiment, the one or more input modules may include a first key input device 310 and/or a second key input device 311. In the illustrated example, the first key input device 310 or the second key input device 311 may be positioned in an opening provided in the first side of the first frame 211. The position or number of input modules may vary and are not limited to the example illustrated. In various embodiments, the foldable electronic device 2 may not include some or all of the key input devices, and the key input devices that are not included may be implemented as soft keys by means of the first display module 24 or the second display module 25. In various embodiments, the input module or key input device may include at least one sensor module.

Any one of the one or more connection terminal modules (or, connector modules or interface terminal modules) may include a connector (or an interface terminal) positioned on the inside of the foldable electronic device 2, for example, corresponding to a connector hole 312 formed in the external appearance of the foldable electronic device 2. In the example illustrated, the connector hole 312 may be provided on the first side of the first frame 211. The position or number of connection terminal modules may vary and are not limited to the example illustrated. The foldable electronic device 2 may transmit and/or receive power and/or data with an external electronic device electrically coupled to the connector. In an embodiment, the connector may include a USB connector or an HDMI connector. In various embodiments, any one of the one or more connection terminal modules may include an audio connector (e.g., a headphone connector or an earset connector), and a connector hole provided in the external appearance of the foldable electronic device 2 corresponding to the audio connector. In various embodiments, any one of the one or more connection terminal modules may include a connector for a memory card positioned inside the foldable electronic device 2, and a connector hole formed in the external appearance of the foldable electronic device 2 corresponding to the connector for the memory card.

According to various embodiments, the foldable electronic device 2 may include a detachable pen input device (e.g., an electronic pen, a digital pen, or a stylus pen) (not illustrated). The pen input device may be implemented, for example, such that the pen input device may be inserted into the inner space of the first housing 21 or the second housing 22. In another example, the pen input device may be removably attached to the hinge housing 23. The hinge housing 23 may include a recess, and the pen input device may fit into the recess.

The foldable electronic device 2 may further include various constituent elements, depending on the form in which the foldable electronic device is provided. These constituent elements are not all enumerated as there are many variations in accordance with the convergence trend of the foldable electronic device 2, but additional constituent elements equivalent to the above-mentioned constituent elements may be included in the foldable electronic device 2. In various embodiments, specific constituent elements may be excluded from the above constituent elements or replaced by other constituent elements, depending on the form in which the constituent elements are provided.

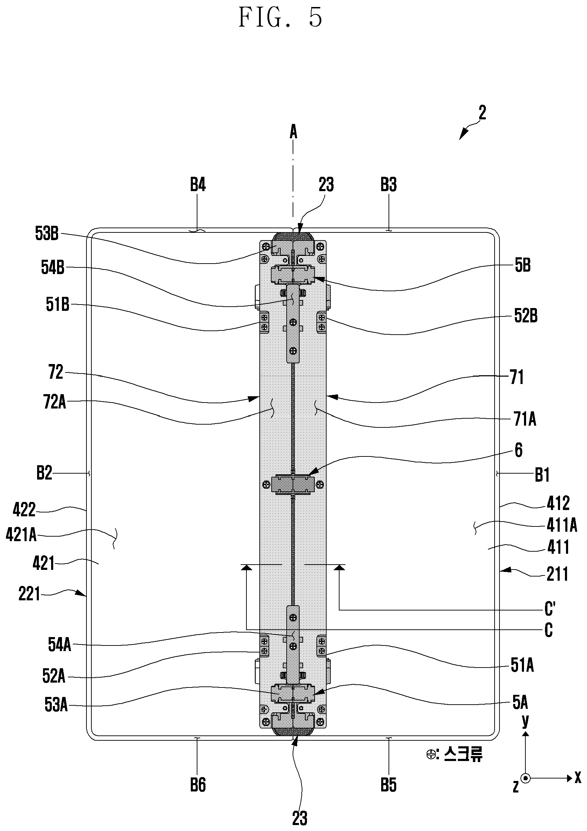

FIG. 4 is an exploded perspective view illustrating the foldable electronic device 2 in the unfolded state according to an embodiment of the disclosure. FIG. 5 is a view illustrating a portion of the foldable electronic device 2 in the unfolded state according to an embodiment of the disclosure. FIG. 6 is a cross-sectional view illustrating a portion of the foldable electronic device 2 that is cut along lines C-C' in FIG. 5 according to an embodiment of the disclosure.

With reference to FIGS. 4, 5, and 6, the foldable electronic device 2 includes a foldable housing 20 and a (first) flexible printed circuit board 81. According to embodiments, the foldable electronic device 2 may include a first display module 24, and/or a second flexible printed circuit board 82. In further embodiments, a first seal portion (or a first seal member or first seal material) 91, and/or a second seal portion (or a second seal member or second seal material) 92 may be included.

The foldable housing 20 includes the first housing 21 and the second housing 22. The foldable housing 20 further includes a hinge portion H. The foldable housing 20 may further include the first hinge module (or first hinge assembly) 5A, the second hinge module (or second hinge assembly) 5B, a guide rail assembly (or a third hinge module) 6, the hinge housing 23, a first plate (or a first wing plate) 71, and/or a second plate (or a second wing plate) 72.. In embodiments, the hinge portion H may include the first hinge module 5A, a first plate 71 and a second plate 72. The hinge portion H may further include the second hinge module 5B, the guide rail assembly 6 and/or the hinge housing 23.

According to an embodiment, the first housing 21 may include the first frame 211. The first frame 211 may include the first support portion 411 and the first side 412. The first frame 211 may be provided in any form, including the first support portion 411 and the first side 412. The first support portion 411 is an internal structure positioned inside the foldable electronic device 2 corresponding to the first housing 21 and may be referred to by various other terms, such as "first bracket," "first support," "first support member," or "first support structure". The second housing 22 may include the second frame 221. The second frame 221 may include the second support portion 421 and the second side 422. The second frame 221 may be provided in any form, including the second support portion 421 and the second side 422. The second support portion 421 is an internal structure positioned inside the foldable electronic device 2 corresponding to the second housing 22 and may be referred to by various other terms such as "second bracket," "second support," "second support member," or "second support structure". At least a portion of the first frame 211 and/or at least a portion of the second frame 221 may be formed of a metallic material and/or a non-metallic material (e.g., a polymer). The electrical constituent elements (or electronic components), or various members related to the electrical constituent elements, may be disposed on the first frame 211 or the first support portion 411, or may be supported by the first frame 211 or the first support portion 411. The first support portion 411 may include a first support area 411A directed toward the first display area ①, and a third support area 411B directed in a direction substantially opposite to the first support area 411A (see FIG. 6). The first display area ① of the first display module 24 may be disposed in the first support area 411A of the first support portion 411. Various constituent elements, such as a printed circuit board or a battery, may be disposed in the third support area 411B (see FIG. 6). The second support portion 421 may include a second support area 421A directed toward the second display area②, and a fourth support area 421B directed in a direction substantially opposite to the second support area 421A (see FIG. 6). The second display area ② of the first display module 24 may be disposed in the second support area 421A of the second support portion 421. Various constituent elements, such as a printed circuit board or a battery, may be disposed in the fourth support area 421B (see FIG. 6). The first display area ① may be disposed on the first support portion 411, and the second display area ② may be disposed on the second support portion 421, by means of various adhesive materials (or bonding materials). For example, the adhesive materials may include thermo-reactive adhesive materials (or thermo-reactive bonding materials), photo-reactive adhesive materials (or photo-reactive bonding materials), general adhesives (or general glues), and/or double-sided tapes.

According to an embodiment (see FIG. 5), the foldable housing 20 may include a first bezel B1, a second bezel B2, a third bezel B3, a fourth bezel B4, a fifth bezel B5, and/or a sixth bezel B6. The first bezel B1, the third bezel B3, and the fifth bezel B5 may be included on the first side 412 of the first frame 211. The second bezel B2, the fourth bezel B4, and the sixth bezel B6 may be included on the second side 422 of the second frame 221. The first bezel B1 and the second bezel B2 may extend parallel to a direction of the center line A of the foldable electronic device 2 (e.g., in the y-axis direction). The first bezel B1 may be positioned corresponding to the first edge E1 (see FIG. 2) of the display area 24A, and the second bezel B2 may be positioned corresponding to the second edge E2 (see FIG. 2) of the display area 24A. The third bezel B3 may extend from one end of the first bezel B1 to a direction perpendicular to the direction of the center line A of the electronic device 2. The fifth bezel B5 may extend from the other end of the first bezel B1 to a direction perpendicular to the direction of the center line A of the electronic device 2 and be substantially parallel to the third bezel B3. The fourth bezel B4 may extend from one end of the second bezel B2 to a direction perpendicular to the direction of the center line A of the electronic device 2. The sixth bezel B6 may extend from the other end of the second bezel B2 to a direction perpendicular to the direction of the center line A of the electronic device 2 and be substantially parallel to the fifth bezel B5. In the unfolded state of the foldable electronic device 2, the third bezel B3 and the fourth bezel B4 may be positioned corresponding to the third edge E3 of the display area 24A (see FIG. 2). In the unfolded state of the foldable electronic device 2, the fifth bezel B5 and the sixth bezel B6 may be positioned corresponding to the fourth edge E4 of the display area 24A (see FIG. 2). In the folded state of the foldable electronic device 2 (see FIG. 3), the first bezel B1 and the second bezel B2 may be aligned. In the folded state of the foldable electronic device 2, the third bezel B3 and the fourth bezel B4 may be aligned. In the folded state of the foldable electronic device 2, the fifth bezel B5 and the sixth bezel B6 may be aligned.

According to various embodiments, the foldable electronic device 2 may include a first inner support (not illustrated) positioned in the inner space of the first housing 21 (see FIG. 2) corresponding to (or facing) the first cover 212 (see FIG. 2). The first inner support, for example, may cover and protect constituent elements such as a printed circuit board or a battery disposed between the first support portion 411 and the first cover 212. In various embodiments, the first inner support may include a non-metallic material, and a non-conductive pattern, which is utilized as an antenna radiator, may be disposed on the first inner support. The first frame 211 may be referred to as a "first front case" and the first inner support may be referred to as a "first rear case".

According to various embodiments, the foldable electronic device 2 may include a second inner support (not illustrated) positioned in the inner space of the second housing 22 (see FIG. 2) corresponding to (or facing) the second cover 222 (see FIG. 2). The second inner support, for example, may cover and protect constituent elements such as a printed circuit board or a battery disposed between the second support portion 421 and the first cover 212. The second frame 221 may be referred to as a "second front case" and the second inner support may be referred to as a "second rear case".

According to an embodiment, with reference to a cross-sectional view 24S of the first display module 24, the first display module 24 may include a flexible display 240, a transparent cover 245, an optical transparent adhesive member (or optical transparent bonding member) 246, and/or a support sheet 247. The flexible display 240 may be coupled to the transparent cover 245 by means of an optically clear adhesive member 246 (e.g., optical clear adhesive (OCA), optical clear resin (OCR), or super view resin (SVR)). The transparent cover 245 (e.g., a window) may cover the flexible display 240 to protect the flexible display 240 from the outside. The transparent cover 245 may be in the form of a thin film having bendability (e.g., a thin film layer). The transparent cover 245 may include, for example, a plastic film (e.g., polyimide (PI) film) or a thin film glass (e.g., ultra-thin glass (UTG)). In various embodiments, the transparent cover 245 may include a plurality of layers. For example, the transparent cover 245 may be in the form of a plastic film or a thin film glass with various coating layers disposed thereon. The transparent cover 245 may be in the form in which at least one protective layer or coating layer that includes a polymeric material (e.g., polyester (PET), polyimide (PI), or thermoplastic polyurethane (TPU)) is disposed on a plastic film or a thin film glass. In various embodiments, the transparent cover 245 and the optical transparent adhesive member 246 may be defined or interpreted as a portion of the flexible display 240. In various embodiments, the transparent cover 245 may be interpreted as a portion of the foldable housing 20 (see FIG. 2) rather than the first display module 24. The flexible display 240 may include, for example, a display panel 241, a base film 242, a lower panel 243, and/or an optical layer 244. The display panel 241 may be positioned between the optical layer 244 and the base film 242. The base film 242 may be positioned between the display panel 241 and the lower panel 243. The optical layer 244 may be positioned between the optical transparent adhesive member 246 and the display panel 241. Various polymers of adhesive materials (or bonding members) or bonding materials (or bonding members) may be disposed between the display panel 241 and the base film 242, between the base film 242 and the lower panel 243, and/or between the display panel 241 and the optical layer 244. The display panel 241 may include, for example, a light-emitting layer 241a, a thin film transistor (TFT) film (or a TFT substrate) 241b, and/or an encapsulation layer (e.g., a thin-film encapsulation (TFE)) 241c. The light emitting layer 241a may include a plurality of pixels implemented as light emitting devices, such as, for example, organic light emitting diode (OLED) or micro LED. The light emitting layer 241a may be disposed on the TFT film 241b by means of an organic vapor deposition (e.g., evaporation). The TFT film 241b may be positioned between the light emitting layer 241a and the base film 242. The TFT film 241b may refer to a film structure in which at least one TFT is disposed on a flexible substrate (e.g., a PI film) through a series of processes such as deposition, patterning, and/or etching. The at least one TFT may control a current relative to a light emitting element of the light emitting layer 241a to turn a pixel on or off, or to adjust the brightness of the pixel. The at least one TFT may be implemented as, for example, an amorphous silicon (a-Si) TFT, a liquid crystalline polymer (LCP) TFT, a low-temperature polycrystalline oxide (LTPO) TFT, or a low-temperature polycrystalline silicon (LTPS) TFT. In an embodiment, the display panel 241 may include a storage capacitor, which may maintain a voltage signal to a pixel, maintain a voltage on a pixel within a frame, or reduce changes in the gate voltage of the TFT due to a leakage current during the time of emitting light. The storage capacitor may maintain the voltage applied to the pixel for a predetermined time interval by a routine that controls the at least one TFT (e.g., initialization, data write). In an embodiment, the display panel 241 may be implemented on the basis of an OLED, and the encapsulation layer 241c may cover the light-emitting layer 241a. The organic material and electrodes that produce light in an OLED are very sensitive to oxygen and/or moisture and may lose the light-emitting properties. To reduce or prevent the loss of the light-emitting properties, the encapsulation layer 241c may seal the light-emitting layer 241a to prevent oxygen and/or moisture from penetrating into the OLED. The base film 242 may include a flexible film made of polymer or plastic, such as polyimide or polyester (PET). The base film 242 may serve to support and protect the display panel 241. In various embodiments, the base film 242 may be referred to as a protective film, a back film, or a back plate. The lower panel 243 may include a plurality of layers for various functions. Adhesive members (or bonding members) (not illustrated) made of various polymers may be disposed between the plurality of layers included in the lower panel 243. The lower panel 243 may include, for example, a light shielding layer 243a, a shock absorbing layer 243b, and/or a lower layer 243c. The light shielding layer 243a may be positioned between the base film 242 and the shock absorbing layer 243b. The shock absorbing layer 243b may be positioned between the light shielding layer 243a and the lower layer 243c. The shading layer 243a may block at least some of the light incident from the outside. For example, the light shielding layer 243a may include an embossed layer. The embossed layer may be a black layer which includes a bumpy pattern. The shock absorbing layer 243b may reduce an external impact on the flexible display 240. For example, the shock absorbing layer 243b may include a sponge layer or a cushion layer. The lower layer 243c may diffuse, disperse, or dissipate heat generated by the foldable electronic device 2 or the flexible display 240. The lower layer 243c may absorb or shield electromagnetic waves. The lower layer 243c may reduce an external impact on the foldable electronic device 2 or the flexible display 240. For example, the lower layer 243c may include a composite sheet 243d or a copper sheet 243e. In an embodiment, the composite sheet 243d may be a sheet processed by combining layers or sheets with different properties. For example, the composite sheet 243d may include at least one of polyimide or graphite. The composite sheet 243d may also be replaced by a single sheet that includes a single material (e.g., polyimide, or graphite). The composite sheet 243d may be positioned between the shock absorbing layer 243b and the copper sheet 243e. The copper sheet 243e may be replaced by a variety of other metal sheets. In some embodiments, at least a portion of the lower layer 243c is a conductive member (e.g., a metal plate), which may be used to help reinforce the stiffness of the foldable electronic device 2, to shield ambient noise, and to dissipate heat emitted from nearby heat dissipating components (e.g., a display driving circuit) (e.g., a display drive integrated circuit (DDI)). The conductive member may include, for example, at least one of copper (Cu), aluminum (Al), stainless steel, or CLAD (e.g., a layered member in which stainless steel and aluminum are alternately disposed). The lower layer 243c may include various other layers for various other functions. In various embodiments (not illustrated), at least one additional polymer layer (e.g., a layer including PI, PET, or TPU) may be disposed on the back surface of the display panel 241 in addition to the base film 242. In various embodiments, at least one of the plurality of layers included in the lower panel 243 (e.g., the light shielding layer 243a, the shock absorbing layer 243b, the composite sheet 243d, and the copper sheet 243e) may be omitted. In various embodiments, the order of disposition of the plurality of layers included in the lower panel 243 may vary without being limited to the embodiment illustrated. The optical layer 244 may include, for example, a polarizing layer, or polarizer, or a phase retardation layer, or retarder. The polarizing layer and phase retardation layer may improve outdoor visibility of the screen. The optical layer 244, for example, may selectively pass light that is generated from a light source of the display panel 241 and oscillates in a predetermined direction. In various embodiments, a single layer combining the polarization layer and the phase retardation layer may be provided, and such a single layer may be interpreted as a "circular polarization layer". The optical transparent adhesive member 246 may be positioned between the transparent cover 245 and the optical layer 244. In various embodiments, the polarization layer (or circular polarization layer) may be omitted. In this case, a black pixel define layer (PDL) and/or a color filter may be provided in place of the polarization layer. The foldable electronic device 2 may include a touch sensing circuit (e.g., a touch sensor) (not illustrated). The touch sensing circuit may be implemented as a transparent conductive layer (or film) based on various conductive materials such as indium tin oxide (ITO). In an embodiment, the touch sensing circuit may be disposed between the transparent cover 245 and the optical layer 244 (e.g., add-on type). In an embodiment, the touch sensing circuit may be disposed between the optical layer 244 and the display panel 241 (e.g., on-cell type). In an embodiment, the display panel 241 may include the touch sensing circuit or touch sensing function (e.g., in-cell type). In various embodiments, the display panel 241 may be based on an OLED and include the encapsulation layer 241c disposed between the light emitting layer 241a and the optical layer 244. The encapsulation layer 241c may serve as a pixel protection layer to protect the plurality of pixels of the light emitting layer 241a. In an embodiment (not illustrated), the flexible display 240 may include a conductive pattern, such as a metal mesh (e.g., aluminum metal mesh), as the touch sensing circuit disposed on the encapsulation layer 241c between the encapsulation layer 241c and the optical layer 244. For example, the metal mesh may have greater durability than the transparent conductive layer implemented with ITO in response to the bending of the flexible display 240. In various embodiments, the flexible display 240 may further include a pressure sensor (not illustrated) that is capable of measuring the intensity (pressure) of a touch. The plurality of layers included in the display panel 241 or the lower panel 243, and the layered structure of the layers or the order of layering, may vary. The flexible display 240 may be implemented by omitting some of the constituent elements, or by adding other constituent elements, depending on the form in which the flexible display is provided, or the convergence trend.

According to an embodiment, a support sheet (or, a support plate or support layer) 247 may be disposed on a back surface of the flexible display 240. The back surface of the flexible display 240 may be a side positioned opposite a side on which light is emitted from the display panel 241 which includes a plurality of pixels. The support sheet 247 may be disposed (e.g., attached) to a back surface of the lower panel 243 of the flexible display 240 by covering at least a portion of the lower panel 243. The support sheet 247 may be coupled to the lower panel 243 by means of an adhesive or bonding material. The adhesive material (or bonding material) between the flexible display 240 and the support sheet 247 may include, for example, a thermoresponsive adhesive material (or thermoresponsive bonding material), a photoresponsive adhesive material (or photoresponsive bonding material), a conventional adhesive (or conventional glue), or a double-sided tape. In another example, the adhesive material (or bonding material) may include various polymers such as triazine thiols, dithiopyrimitines, or silane-based compounds, or organic adhesive materials (or organic bonding materials) such as sealants. The support sheet 247 may contribute to the durability (e.g., enhanced stiffness) of the first display module 24. The support sheet 247 may reduce the influence of loads or stresses that may occur in folding of the foldable housing 20 (see FIG. 2) on the first display module 24 (or the flexible display 240). The support sheet 247 may reduce or prevent the first display module 24 from breaking due to forces transmitted when the foldable housing 20 is folded. In an embodiment, the support sheet 247 may include a metallic material. The support seat 247 may include, for example, stainless steel. The support sheet 247 may include various other metallic materials. In various embodiments, the support sheet 247 may include an engineering plastic.

According to an embodiment, the support sheet 247 may include a lattice structure (not illustrated) that is at least partially overlapped with the third display area ③ of the first display module 24. The lattice structure may include, for example, a plurality of openings (or slits) provided in the support sheet 247. The lattice structure may refer to a pattern structure with the plurality of openings regularly arranged. The plurality of openings may be formed periodically, may have substantially the same shape, and may be repeatedly arranged at a predetermined interval. The lattice structure may reduce the degradation of the flexibility of the third display area ③. In various embodiments, the lattice structure including the plurality of openings may be referred to by other terms such as " an opening pattern," " a hole pattern," or "a lattice pattern". In various embodiments, the support sheet 247 may include a recess pattern (not illustrated) that includes a plurality of recesses, in replacement of the lattice structure. The recess pattern may refer to, for example, a pattern structure in which a plurality of recesses are regularly arranged in the form of being recessed and provided on a first surface of the support sheet 247 that faces the lower panel 243 of the flexible display 240 or a second surface of the support sheet 247 positioned opposite to the first surface. In various embodiments, the lattice structure or recess pattern may extend to portions of the support sheet 247 corresponding to the first display area ① and/or the second display area ② of the first display module 24. In various embodiments, the support sheet 247 including the lattice structure or recess pattern or the conductive member corresponding thereto may be provided in a plurality of layers.

According to various embodiments, the support sheet 247 may reduce electromagnetic interference (EMI) with respect to the flexible display 240.

According to various embodiments, the support sheet 247 may diffuse or disperse heat dissipated from a heat dissipating component (e.g., a display drive circuit such as a display drive integrated circuit (DDI) or DDI chip).

According to various embodiments, the support sheet 247 may be omitted.

According to various embodiments, the support seat 247 may be interpreted as a separate element from the first display module 24.

According to an embodiment, the first hinge module 5A, the second hinge module 5B, and the guide rail assembly 6 may connect the first frame 211 and the second frame 221. The first frame 211 and the second frame 221 may be rotatably connected to each other by means of the first hinge module 5A, the second hinge module 5B, and the guide rail assembly 6. The first hinge module 5A, the second hinge module 5B, and the guide rail assembly 6 may be disposed along a center line A of the foldable electronic device 2, and the guide rail assembly 6 may be positioned between the first hinge module 5A and the second hinge module 5B. In an embodiment, the guide rail assembly 6 may be positioned corresponding to a center between the first hinge module 5A and the second hinge module (e.g., a point on the center line A that is substantially equidistant from the first hinge module 5A and the second hinge module 5B).

According to an embodiment, the first hinge module 5A may include a first bracket 51A, a second bracket 52A, and a bracket connector 53A. The first bracket 51A may be disposed or coupled to the first support area 411A of the first frame 211, for example, by means of a screw-fastening. The second bracket 52A may be disposed or coupled to the second support area 421A of the second frame 221, for example, by means of a screw-fastening. The bracket connector 53A may connect the first bracket 51A and the second bracket 52A. The first bracket 51A and the second bracket 52A may be rotatable relative to the bracket connector 53A.

According to an embodiment, the bracket connector 53A of the first hinge module 5A may be constituted such that the first frame 211 to which the first bracket 51A is fixed and the second frame 221 to which the second bracket 52A is fixed may be rotatable in opposite directions and with the same angle. The bracket connector 53A may be constituted such that the first frame 211 to which the first bracket 51A is fixed, and the second frame 221 to which the second bracket 52A is fixed, may be rotated and held at one or more predetermined angles. The bracket connector 53A may have a free-stop function, for example. The bracket connection 53A may be constituted to provide a force that allows the first frame 211 to which the first bracket 51A is fixed and the second frame 221 to which the second bracket 52A is fixed, to be mutually rotated. The bracket connector 53A may be constituted with a combination of at least one shaft, at least one cam gear, and/or at least one compression spring providing resilience.

The second hinge module 5B may be provided substantially the same as the first hinge module 5A, and may include, for example, a first bracket 51B, a second bracket 52B, and/or a bracket connector 53B. In an embodiment, the second hinge module 5B may be disposed on the foldable electronic device 2 in a disposition direction opposite to the first hinge module 5A. The first bracket 51B of the second hinge module 5B may be disposed or coupled to the second support area 421A of the second frame 221, and the second bracket 52B of the second hinge module 5B may be disposed or coupled to the first support area 411A of the first frame 211.

According to an embodiment, the first hinge module 5A, the second hinge module 5B, and the guide rail assembly 6 may be coupled to the hinge housing 23 and may be coupled, for example, by means of screws. The hinge housing 23 may be connected to the first frame 211 and the second frame 221 by means of the first hinge module 5A, the second hinge module 5B, and the guide rail assembly 6. The hinge housing 23 may include a recess provided on the other surface opposite to one surface that is exposed to the outside in the folded state of the foldable electronic device 2 (see FIG. 3). The bracket connector 53A of the first hinge module 5A, the bracket connector 53B of the second hinge module 5B, and the guide rail assembly 6 may be disposed in the recess of the hinge housing 23 by means of screw-fastening.

According to an embodiment, the first plate (e.g., the first wing plate) 71 may be positioned corresponding to the first frame 211 and the second plate (e.g., the second wing plate) 72 may be positioned corresponding to the second frame 221. The first plate 71 and the second plate 72 may each be shaped such that a first width in the direction of the center line A (e.g., in the y-axis direction) is relatively larger than a second width in a direction perpendicular to the direction of the center line A, and may be overlapped with the first hinge module 5A, the second hinge module 5B, and/or the guide rail assembly 6. The first plate 71 and the second plate 72 may be coupled with the first hinge module 5A, the second hinge module 5B, and the guide rail assembly 6.

According to an embodiment, the first plate 71 may be connected with the bracket connector 53A of the first hinge module 5A and the bracket connector 53B of the second hinge module 5B. The second plate 72 may be connected with the bracket connector 53A of the first hinge module 5A and the bracket connector 53B of the second hinge module 5B. In an embodiment, the first plate 71 and the second plate 72 may be provided to be substantially symmetrical to each other with respect to the center line A of the foldable electronic device 2.

According to an embodiment, the first plate 71 may include a first surface 71A provided corresponding to the third display area ③ of the first display module 24. The second plate 72 may include a second surface 72A provided corresponding to the third display area ③ of the first display module 24. In the unfolded state of the foldable electronic device 2 (see FIG. 2), the first surface 71A of the first plate 71 may support a portion of the third display area ③, and the second surface 72A of the second plate 72 may support a portion of the third display area ③. The first surface 71A of the first plate 71 may include a flat surface capable of supporting a one side area of the third display area ③ with respect to the center line A of the foldable electronic device 2 in the unfolded state of the foldable electronic device 2. The second surface 72A of the second plate 72 may include a flat surface capable of supporting the other side area of the third display area ③ with respect to the center line A of the foldable electronic device 2 in the unfolded state of the foldable electronic device 2. In the unfolded state of the foldable electronic device 2, the first surface 71A of the first plate 71 and the second surface 72A of the second plate 72 may form an angle of substantially about 180 degrees and be disposed with no substantial height difference. In the unfolded state of the foldable electronic device 2, even when an external force (e.g., an external pressure such as a touch input using a user's finger or a touch input using an electronic pen) is applied to the third display area ③, the third display area ③ may be maintained flat by the support of the first plate 71 and the second plate 72.

According to an embodiment, the bracket connector 53A of the first hinge module 5A may include a center plate 54A aligned with the center line A of the foldable electronic device 2. The bracket connector 53B of the second hinge module 5B may include a center plate 54B aligned with the center line A of the foldable electronic device 2. The center plate 54A of the first hinge module 5A and the center plate 54B of the second hinge module 5B may support a portion of the third display area ③ of the first display module 24 that corresponds to a portion between the first surface 71A of the first plate 71 and the second surface 72A of the second plate 72 in an unfolded state of the foldable electronic device 2. The center plate 54A of the first hinge module 5A and the center plate 54B of the second hinge module 5B may reduce or prevent a sagging phenomenon or a creep phenomenon of a portion of the third display area ③ that corresponds to a gap between the first surface 71A of the first plate 71 and the second surface 72A of the second plate 72 in the unfolded state of the foldable electronic device 2.

According to an embodiment, the guide rail assembly 6 may include a first slider 61, a second slider 62, and a guide rail 63. The guide rail 63 may be disposed or coupled to the hinge housing 23. In the folded state of the foldable electronic device 2 (see FIG. 3), the hinge housing 23 may include a recess provided on the other surface opposite the one surface exposed to the outside, and the guide rail 63 may be disposed in the recess of the hinge housing 23 by means of a screw-fastening. The first slider 61 may be slidably disposed on the guide rail 63 relative to the guide rail 63 and coupled to the first plate 71, for example, by means of a screw. The second slider 62 may be slidably disposed on the guide rail 63 relative to the guide rail 63 and coupled to the second plate 72, for example, by means of a screw. The guide rail 63 may include a first guide rail that is in sliding pair with the first slider 61, and a second guide rail that is in sliding pair with the second slider 62. In response that a relative position of the first plate 71 with respect to the first frame 211, and a relative position of the second plate 72 with respect to the second frame 221, vary due to a motion (or state change) of the first hinge module 5A and the second hinge module 5B when an angle between the first frame 211 and the second frame 221 changes, the first guide rail may be constituted to guide a path in which the first slider 61 coupled with the first plate 71 moves relative to the guide rail 63, and the second guide rail may be constituted to guide a path in which the second slider 62 coupled with the second plate 72 moves relative to the guide rail 63. The structure in which the guide rail assembly 6 between the first hinge module 5A and the second hinge module 5B is coupled with the first plate 71 and the second plate 72 may reduce or prevent the first plate 71 and the second plate 72 from lifting. In an embodiment, in the unfolded state of the foldable electronic device 2, the guide rail assembly 6 may support a portion of the third display area ③ of the first display module 24 corresponding to a portion between the first surface 71A of the first plate 71 and the second surface 72A of the second plate 72.

According to an embodiment, when the foldable electronic device 2 is transitioned from the unfolded state (see FIG. 2) to the folded state (see FIG. 3), the hinge portion H may be constituted to provide a space in which the third display area ③ of the first display module 24 may be disposed in a bent form that may reduce bending stress. When the foldable electronic device 2 is transitioned from the unfolded state to the folded state, the hinge portion H may be constituted to provide a space in which the third display area ③ may be disposed in a bent form that may reduce buckling. In one embodiment, when the foldable electronic device 2 is switched from the unfolded state to the folded state, the third display area ③ may be disposed in a teardrop form or a dumbbell form, which may reduce breakage or permanent deformation. In the folded state of the foldable electronic device 2, the third display area ③ may be disposed in a bent form that may reduce a collision (e.g., bending stress) between a compressive stress generated in one side area of the third display area ③ and a tensile stress generated in one side area of the third display area ③, with respect to a neutral surface (neutral plane) inside the third display area ③.

The first flexible printed circuit board 81 is disposed across the hinge portion H. In an embodiment, where an additional second flexible printed circuit board 82 is provided, also the second flexible printed circuit board 82 may be disposed across the hinge portion H. A first end 8101 of the first flexible printed circuit board 81 includes a first connector (e.g., a first FPCB connector), and a second end 8102 of the first flexible printed circuit board 81 includes a second connector (e.g., a second FPCB connector). The first end 8101 of the first flexible printed circuit board 81 may be referred to "a first connector end" and the second end 8102 of the flexible printed circuit board 81 may be referred to "a second connector end." The first connector is electrically coupled to a first element (e.g., connector) located or accommodated in the first housing 21. The second connector is electrically coupled to a second element (e.g., connector) located or accommodated in the second housing 22. A third end 8201 of the second flexible printed circuit board 82 may include a third connector (e.g., a third FPCB connector), and a fourth end 8202 of the second flexible printed circuit board 82 may include a fourth connector (e.g., a fourth FPCB connector). The third connector may be electrically coupled to the third element (e.g., connector) located or accommodated in the first housing 21. The fourth connector may be electrically coupled to the fourth element (e.g., connector) located or accommodated in the second housing 22. The first flexible printed circuit board 81 may be in the form of a film with a thickness between a first substrate surface 81A and a second substrate surface 81B, which is directed in a direction opposite to the first substrate surface 81A, and may include signal lines (or electrical paths) that electrically connect the first end 8101 and the second end 8102, and conductive patterns to constitute a ground area to reduce electromagnetic interference (EMI) associated with the signal lines. The second flexible printed circuit board 82 may be in the form of a film with a thickness between a third substrate surface 82A and a fourth substrate surface (not illustrated) that is directed in a direction opposite to the third substrate surface 82A, and may include signal lines (or electrical paths) electrically that connect the third end 8201 and the fourth end 8202, and conductive patterns to constitute a ground area to reduce electromagnetic interference (EMI) associated with the signal lines.

The first end 8101 of the first flexible printed circuit board 81 is electrically connected to an electrical element, such as a printed circuit board. The printed circuit board may be disposed in the third support area 411B of the first support portion 411 included in the first frame 211. The second end 8102 of the first flexible printed circuit board 81 is electrically connected to an electrical element, such as a printed circuit board. The printed circuit board may be disposed in the fourth support area 421B of the second support portion 421 included in the second frame 221. The third end 8201 of the second flexible printed circuit board 82 may be electrically connected to an electrical element, such as a printed circuit board disposed in the third support area 411B of the first support portion 411 included in the first frame 211. The fourth end 8202 of the second flexible printed circuit board 82 may be electrically connected to an electrical element, such as a printed circuit board disposed in the fourth support area 421B of the second support portion 421 included in the second frame 221.

The first flexible printed circuit board 81 includes a first area 811, a second area 812, a third area 813, and a fourth area 814. The third area 813 is a portion of the first flexible printed circuit board 81 that connects the first area 811 and the second area 812 and may be in a bent form (or an elbowed or angled form). The first area 811 may extend from the third area 813 to the first end 8101. The second area 812 may extend from the third area 813 to the second end 8102. The fourth area 814 may extend from the first area 811. Although not illustrated separately, the fourth area 814 may extend from the second area 812, or the third area 813.

According to an embodiment, the first support portion 411 of the first frame 211 may include a first opening (or first hole or first through hole) 401. The second support portion 421 of the second frame 221 may include a second opening (or second hole or second through hole) 402. The second area 812 of the first flexible printed circuit board 81 may penetrate the first opening 401 and the second opening 402. In an embodiment, the first opening 401 and the second opening 402 may be overlapped and aligned with each other in the folded state of the foldable electronic device 2 (see FIG. 3). The second area 812 of the first flexible printed circuit board 81 may include a first fixing portion F1 and a second fixing portion F2. Further, the first flexible printed circuit board 81 may include a first extension portion 812a, a second extension portion 812b, and/or a third extension portion 812c. The first fixing portion F1 of the second area 812 may be positioned between the first plate (e.g., the first wing plate) 71 and the first hinge housing cover 213 (or the first support portion 411). The first fixing portion F1 of the second area 812 may be coupled to the first hinge housing cover 213 (or the first support portion 411 of the first frame 211) or the first plate 71 by means of various coupling methods, such as bonding with an adhesive material or bonding materials, or screw-fastening. The second fixing portion F2 of the second area 812 may be positioned between the second plate (e.g., the second wing plate) 72 and the second hinge housing cover 223 (or the second support portion 421). The second fixing portion F2 of the second area 812 may be coupled to the second hinge housing cover 223 (or the second support portion 421 of the second frame 221) or the second plate 72 by means of various coupling methods, such as bonding with an adhesive material or bonding materials, or screw-fastening. The first extension portion 812a of the second area 812 may be a portion between the first fixing portion F1 and the second fixing portion F2 of the first flexible printed circuit board 81. When the foldable electronic device 2 transitions between the unfolded state and the folded state, a relative position between the first fixing portion F1 and the second fixing portion F2 may change, and the first extension portion 812a may be disposed in a form corresponding to the relative position between the first fixing portion F1 and the second fixing portion F2. When the foldable electronic device 2 transitions between the unfolded and folded states, the hinge housing 23 may include a recess that contributes to allowing the first extension portion 812a of the second area 812 to be disposed with reduced stress. The second extension portion 812b of the second area 812 may be a portion between the first fixing portion F1 and the third area 813 of the first flexible printed circuit board 81. The second extension portion 812b of the second area 812 may penetrate the first opening 401 included in the first support portion 411 of the first frame 211. The first area 811, a portion of the second extension portion 812b included in the second area 812, the third area 813, and the fourth area 814 may be positioned between the first support portion 411 and the first cover 212 (see FIG. 2) of the first frame 211. The first area 811 of the first substrate surface 81A of the first flexible printed circuit board 81, a portion of the second extension portion 812b included in the second area 812, the third area 813, and some areas included in the fourth area 814 may at least partially face the third support area 411B of the first support portion 411. The third extension portion 812c of the second area 812 may be a portion between the second fixing portion F2 and the second end 8102 of the first flexible printed circuit board 81. The third extension portion 812c may penetrate the second opening 402 included in the second support portion 421 of the second frame 221. A portion of the third extension portion 812c may be positioned between the second support portion 421 of the second frame 221 and the second cover 222 (see FIG. 2). Some areas included in a portion of the third extension portion 812c of the first substrate surface 81A of the first flexible printed circuit board 81 may be at least partially face the fourth support area 421B of the second support portion 421.

According to an embodiment, the first fixing portion F1 and/or the second fixing portion F2 included in the second area 812 of the first flexible printed circuit board 81 may be constituted to be less flexible than other portions of the first flexible printed circuit board 81. The first fixing portion F1 and/or the second fixing portion F2 may be substantially rigid. The first fixing portion F1 may be rigid, including a first reinforcing portion (or first reinforcing member or first reinforcing structure) 815, such as a stiffener, for example. The second fixing portion F2 may be rigid, including a second reinforcing portion (or second reinforcing member or second reinforcing structure) 816, such as a stiffener, for example.

In one embodiment, the first reinforcing portion 815 may include a screw hole for screw-fastening with the first hinge housing cover 213 (or the first support portion 411 of the first frame 211) or the first plate (e.g., the first wing plate) 71. In an embodiment, the second reinforcing portion 816 may include a screw hole for screw-fastening with the second hinge housing cover 223 (or the second support portion 421 of the second frame 221) or the second plate (e.g., the second wing plate) 72. In various embodiments, the first reinforcing portion 815 may include a plate or film disposed on the first substrate surface 81A or the second substrate surface 81B, without being limited to the example illustrated, and the first fixing portion F1 may be less flexible than other portions of the first flexible printed circuit board 81 by the first reinforcing portion 815. In various embodiments, the second reinforcing portion 816 may include a plate or film disposed on the first substrate surface 81A or the second substrate surface 81B, without being limited to the example illustrated, and the second fixing portion F2 may be less flexible than other portions of the first flexible printed circuit board 81 by the second reinforcing portion 816. In various embodiments, the first flexible printed circuit board 81 may be implemented as a rigid FPCB (RFPCB), and the first fixing portion F1 may be substantially rigid without the first reinforcing portion 815, and the second fixing portion F2 may be substantially rigid without the second reinforcing portion 816. In various embodiments, the first fixing portion F1 and/or the second fixing portion F2 may be provided in a form in which a reinforcing portion, such as a stiffener, is omitted and thus flexible.

According to an embodiment, the fourth area (or fixed area) 814 of the first flexible printed circuit board 81 may be disposed, fixed, or coupled to the first support portion 411 of the first frame 211. The third support area 411B of the first support portion 411 may include a fixing area corresponding to the fourth area 814. The fixing area included in the third support area 411B of the first support portion 411 may allow the fourth area 814 of the first flexible printed circuit board 81 to be stably positioned on the first support portion 411.

The fourth area 814 of the first flexible printed circuit board 81 includes a third fixing portion F3. The third fixing portion F3 may be constituted to be less flexible than other portions of the fourth area 814. The third fixing portion F3 may be substantially rigid. The third fixing portion F3 is referred to "a rigid portion" of the fourth area 814. The third fixing portion F3 may be rigid, including, for example, a third reinforcing portion (or third reinforcing member or third reinforcing structure) such as a stiffener. In various embodiments, the third reinforcing portion may include a plate or film disposed on the first substrate surface 81A or the second substrate surface 81B, and the third fixing portion F3 may be less flexible than other portions of the fourth area 814 by the third reinforcing portion. The first flexible printed circuit board 81 may be implemented as an RFPCB, and the third fixing portion F3 may be rigid without the third reinforcing portion. In various embodiments, the third fixing portion F3 may be provided in a form in which the third reinforcing portion is omitted and thus may be flexible.

According to an embodiment, the third fixing portion F3 may be implemented substantially rigidly and flat. The third fixing portion F3 may, for example, include a reinforcing plate (or, a reinforcing film or a reinforcing layer) (e.g., a stiffener) such as to be substantially rigid and flat. The reinforcing plate may, for example, include a glass-reinforced epoxy laminate material (FR4), or polyimide (PI).

According to an embodiment, the third fixing portion F3 may have a thickness thicker than another portion of the fourth area 814. In an embodiment, the third fixing portion F3 may have many more laminated layers than another portion of the fourth area 814. This may enable the third fixing portion F3 to be constituted to be less flexible than other portions of the fourth area 814.

According to an embodiment, the first support portion 411 may include a recess-shaped fixing area in which the third fixing portion F3 of the fourth area 814 may be stably positioned.

According to an embodiment, the third fixing portion F3 of the fourth area 814 may include one or more openings 818 and 819. For example, one opening 818 of the one or more openings 818 and 819 may be a through hole, and the other opening 819 may be a notch. The first support portion 411 of the first frame 211 may include one or more protrusions that are inserted into the one or more openings 818 and 819, respectively. The number or position of openings (e.g., through holes or notches) included in the third fixing portion F3 for coupling with the first support portion 411 of the first frame 211 may vary, without limitation to the example illustrated.

According to an embodiment, an adhesive material or bonding material may be disposed between the third fixing portion F3 of the fourth area 814 and the first support portion 411 of the first frame 211. The third fixing portion F3 may be coupled to the first support portion 411 by means of an adhesive material or bonding material.

According to various embodiments (not illustrated), the third fixing portion F3 of the fourth area 814 may be coupled to the first support portion 411 of the first frame 211, for example, by means of a screw-fastening. The third fixing portion F3 of the fourth area 814 may include one or more screw holes for a screw-fastening, and the first support portion 411 of the first frame 211 may include one or more screw fastening portions aligned correspondingly one-to-one with the one or more screw holes. The screw fastening portion may be a boss including a female thread corresponding to a male thread of a screw.

According to various embodiments (not illustrated), the third fixing portion F3 of the fourth area 814 may be coupled to the first support portion 411 of the first frame 211 by means of a snap-fit fastening. For example, the third fixing portion F3 of the fourth area 814 may include one or more hooks, and the first support portion 411 of the first frame 211 may include one or more hook fastening portions (catching portions) that correspond one-to-one to the one or more hooks.

According to an embodiment, the first flexible printed circuit board 81 includes at least one signal line that electrically connect the first end 8101 and the second end 8102. In an embodiment, the at least one signal line may not be disposed or included in the fourth area 814 or the third fixing portion F3.

According to an embodiment, the first flexible printed circuit board 81 includes a ground area (or a ground pattern) (e.g., a ground plane). In an embodiment, the ground area may not be disposed or included in the fourth area 814 or the third fixing portion F3.

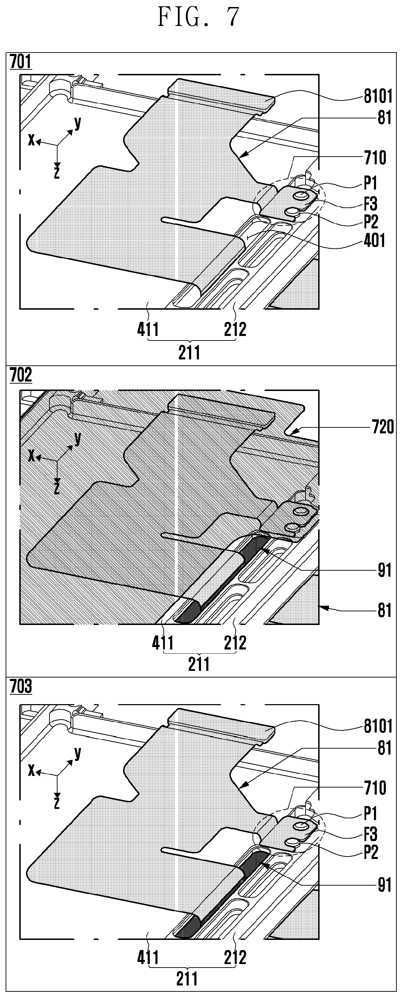

According to an embodiment, in an operation to prioritize a position of the first flexible printed circuit board 81 with respect to the first frame 211 among operations to dispose (or connect) the constituent elements to the foldable housing 20, a disposition guide structure (or disposition guide) including the fourth area 814 (or the third fixing portion F3) and the fixing area of the first support portion 411 (or the first frame 211) of the first flexible printed circuit board 81 may be utilized (for example: a disposition guide structure 710 in FIG. 7). After the operation of prioritizing the position of the first flexible printed circuit board 81 with respect to the first frame 211 is performed by means of the disposition guide structure between the first flexible printed circuit board 81 and the first frame 211, operations of connecting the first flexible printed circuit board 81 with at least one of other components may be performed.

According to an embodiment, the first support portion 411 of the first frame 211 may include a third opening (or third hole or third through hole) 403. The second support portion 421 of the second frame 221 may include a fourth opening (or fourth hole or fourth through hole) 404. The second flexible printed circuit board 82 may penetrate the third opening 403 and the fourth opening 404. The third opening 403 and the fourth opening 404 may be overlapped and aligned with each other in the folded state of the foldable electronic device 2 (see FIG. 3). The first opening 401 and the third opening 403 may be spaced apart from each other in the direction of the center line A of the foldable electronic device 2 (e.g., in the y-axis direction). The second opening 402 and the fourth opening 404 may be spaced apart from each other in the direction of the center line A of the foldable electronic device 2. The second flexible printed circuit board 82 may be constituted at least partially the same or similar to the first flexible printed circuit board 81. The second flexible printed circuit board 82 may include a first area (e.g., the first area 811), a second area (e.g., the second area 812) including a first fixing portion F11 (e.g., the first fixing portion F1) and a second fixing portion F21 (e.g., the second fixing portion F2), and a third area (e.g., the third area 813). The second area of the second flexible printed circuit board 82 may penetrate the third opening 403 and the second opening 402. The first fixing portion F11 may be coupled to the first hinge housing cover 213 (or the first support portion 411 of the first frame 211) or the first plate 71, and the second fixing portion F21 may be coupled to the second hinge housing cover 223 (or the second support portion 421 of the second frame 221) or the second plate 72, by means of various coupling methods, such as a bonding including adhesive or bonding materials, or a screw-fastening.

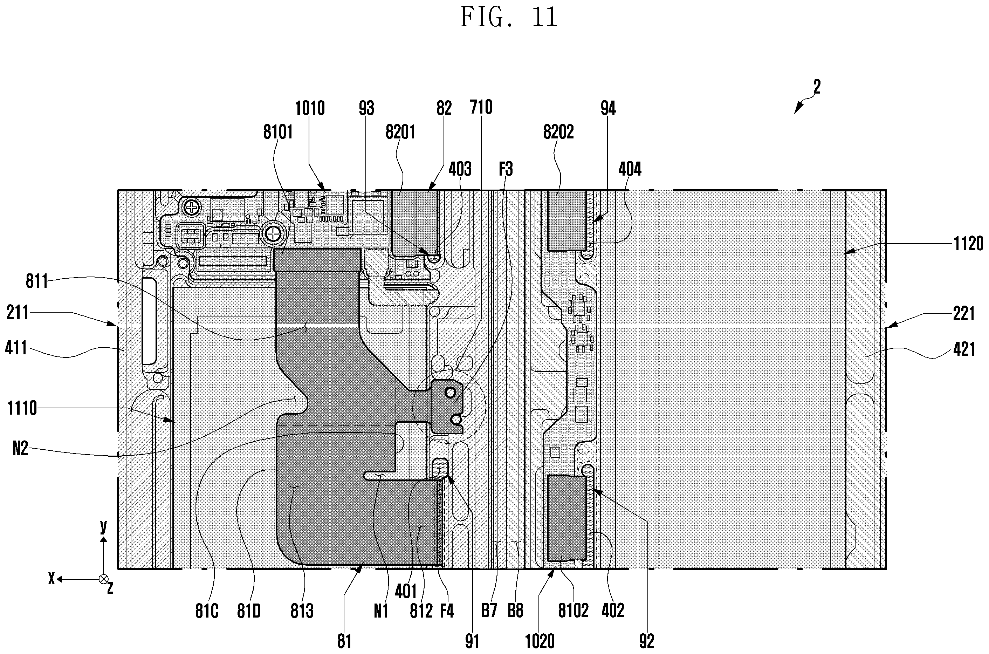

According to an embodiment, the first seal portion 91 may be disposed in the first opening 401 included in the first support portion 411 of the first frame 211. A third seal portion (or third seal member or third seal material) (e.g., see a third seal portion 93 in FIG. 11) may be disposed in the third opening 403 included in the first support portion 411 of the first frame 211. The foldable electronic device 2 may include a first waterproof area (or first waterproof space) and a second waterproof area (or second waterproof space). The first waterproof area may be a space between the first support area 411A of the first support portion 411, the first side 412, and the first display area ① of the first display module 24. The second waterproofing area may be a space between the third support area 411B of the first support portion 411, the first side 412, and the first cover 212 (see FIG. 2). A plurality of electrical constituent elements may be positioned in the first waterproofing area and the second waterproofing area. The first seal portion 91 disposed in the first opening 401 and the third seal portion disposed in the third opening 403 may separate the first waterproof area and the second waterproof area. The first seal portion 91 and/or the third seal portion 93 may reduce or prevent moisture introduced inside the foldable electronic device 2 from the outside from flowing (or moving) through the first opening 401 from the first waterproof area to the second waterproof area, or from the second waterproof area to the first waterproof area. The first seal portion 91 and/or the third seal portion 93, for example, may include a waterproof member or a waterproof material.

According to an embodiment, the first flexible printed circuit board 81 may penetrate the first seal portion 91 disposed in the first opening 401. The second extension portion 812b of the second area 812 of the first flexible printed circuit board 81 may be connected to the first support portion 411 of the first frame 211 by means of the first seal portion 91. The first seal portion 91 may be formed, for example, by filling the first opening 401 with an adhesive material (e.g., a liquid gasket (cured in plage gasket (CIPG))) and then curing the filled adhesive material (e.g., curing by means of a light reaction or thermal reaction). The second flexible printed circuit board 82 may penetrate the third seal portion (e.g., the third seal portion 93 in FIG. 11) disposed in the third opening 403. The second flexible printed circuit board 82 may be connected to the first support portion 411 of the first frame 211 by means of a third seal portion. The third seal portion may be formed, for example, by filling the third opening 403 with an adhesive material (e.g., a liquid gasket) and then curing the filled adhesive material (e.g., curing by means of a light reaction or a thermal reaction). In various embodiments, the first seal portion 91 may be an elastic member or flexible member that is resiliently disposed in the first opening 401 through which the first flexible printed circuit board 81 penetrates. In various embodiments, the third seal portion may be an elastic member or flexible member that is resiliently disposed in the third opening 403 through which the second flexible printed circuit board 82 penetrates. In various embodiments, the first seal portion 91 or the third seal portion may include various adhesive or bonding materials of a polymer.

According to an embodiment, the second seal portion 92 may be disposed in the second opening 402 included in the second support portion 421 of the second frame 221. A fourth seal portion (or fourth seal member or fourth seal material) (e.g., see a fourth seal portion 94 in FIG. 11) may be disposed in the fourth opening 404 included in the second support portion 421 of the second frame 221. The foldable electronic device 2 may include a third waterproof area (or third waterproof space) and a fourth waterproof area (or fourth waterproof space). The third waterproof area may be a space between the second support area 421A of the second support portion 421, the second side 422, and the second display area ② of the first display module 24. The fourth waterproofing area may be a space between the fourth support area 421B of the second support portion 421, the second side 422, and the second cover 222 (see FIG. 2). A plurality of electrical constituent elements may be positioned in the third waterproof area and the fourth waterproof area. The second seal portion 92 disposed in the second opening 402 and the fourth seal portion disposed in the fourth opening 404 may separate the third waterproof area and the fourth waterproof area. The second seal portion 92 and/or the fourth seal portion 94 may reduce or prevent moisture introduced inside the foldable electronic device 2 from the outside from flowing (or moving) through the second opening 402 from the third waterproof area to the fourth waterproof area, or from the fourth waterproof area to the third waterproof area. The second seal portion 92 and/or the fourth seal portion 94, for example, may include a waterproof member or a waterproof material.

According to an embodiment, the first flexible printed circuit board 81 may penetrate the second seal portion 92 disposed in the second opening 402. The third extension portion 812c of the second area 812 of the first flexible printed circuit board 81 may be connected to the second support portion 421 of the second frame 221 by means of the second seal portion 92. The second seal portion 92 may be formed, for example, by filling the second opening 402 with an adhesive material (e.g., a liquid gasket) and then curing the filled adhesive material (e.g., curing by means of a light reaction or a thermal reaction). The second flexible printed circuit board 82 may penetrate the fourth seal portion (e.g., the fourth seal portion 94 in FIG. 11) disposed in the fourth opening 404. The second flexible printed circuit board 82 may be connected to the second support portion 421 of the second frame 221 by means of a fourth seal portion. The fourth seal portion may be formed, for example, by filling the fourth opening 404 with an adhesive material (e.g., a liquid gasket) and then curing the filled adhesive material (e.g., curing by means of a light reaction or a thermal reaction). In various embodiments, the second seal portion 92 may be an elastic member or flexible member that is resiliently disposed in the second opening 402 through which the first flexible printed circuit board 81 penetrates. In various embodiments, the fourth seal portion may be an elastic member or flexible member that is resiliently disposed in the fourth opening 404 through which the second flexible printed circuit board 82 penetrates. In various embodiments, the second seal portion 92 or the fourth seal portion may include various adhesive or bonding materials of a polymer.

FIG. 7 is a view illustrating a process of disposing the first flexible printed circuit board 81, according to an embodiment of the disclosure.

With reference to FIG. 7, in operation 701, the first flexible printed circuit board 81 may be disposed to pass through the first opening 401 of the first frame 211. In operation 701, the third fixing portion F3 of the first flexible printed circuit board 81 may be disposed in the fixing area of the first support portion 411 of the first frame 211. A first protrusion P1 and a second protrusion P2 included in the fixing area of the first support portion 411 may be inserted into openings 818 and 819, respectively, included in the third fixing portion F3 (see FIG. 4). The first flexible printed circuit board 81 may be disposed in a designated position with respect to the first frame 211 by means of the disposition guide structure 710, which includes the third fixing portion F3 of the first flexible printed circuit board 81 and the fixing area of the first support portion 411. A position of the first flexible printed circuit board 81 with respect to the first frame 211 may be preferentially (or primarily) determined by means of the disposition guide structure 710 between the first flexible printed circuit board 81 and the first frame 211 prior to an operation of forming the first seal portion 91 disposed in the first opening 401, an operation of electrically connecting the first end 8101 of the first flexible printed circuit board 81 with the first element disposed on the first frame 211, and an operation of electrically connecting the second end 8102 of the first flexible printed circuit board 81 (see FIG. 4) with the second element disposed on the second frame 221.

According to an embodiment, in operation 702, the first flexible printed circuit board 81 may be stably positioned with respect to the first frame 211 by means of attaching the guide sheet 720. In operation 702, the first opening 401 may be filled with a liquid-type adhesive material (e.g., a gasket (CIPG)). In operation 702, the first seal portion 91 disposed in the first opening 401 may be formed by curing (e.g., curing by light reaction or curing by heat reaction) the liquid-type adhesive material filled in the first opening 401. The first flexible printed circuit board 81 may be connected to the first frame 211 by means of the first seal portion 91 disposed in the first opening 401. The disposition guide structure 710 between the first flexible printed circuit board 81 and the first frame 211, and the guide sheet 720 attached on the basis of the disposition guide structure 710, may reduce or prevent poor curing of the liquid-type adhesive material filled in the first opening 401. The disposition guide structure 710 between the first flexible printed circuit board 81 and the first frame 211, and the guide sheet 720 attached on the basis of the disposition guide structure 710, may enable the first flexible printed circuit board 81 to be stably positioned with respect to the first opening 401 in response to shocks or shaking that may occur during an assembly process, such as a transfer operation, so that reliable curing of the liquid-type adhesive material filled in the first opening 401 may be possible.

According to an embodiment, in operation 703, the guide sheet 720 may be separated.

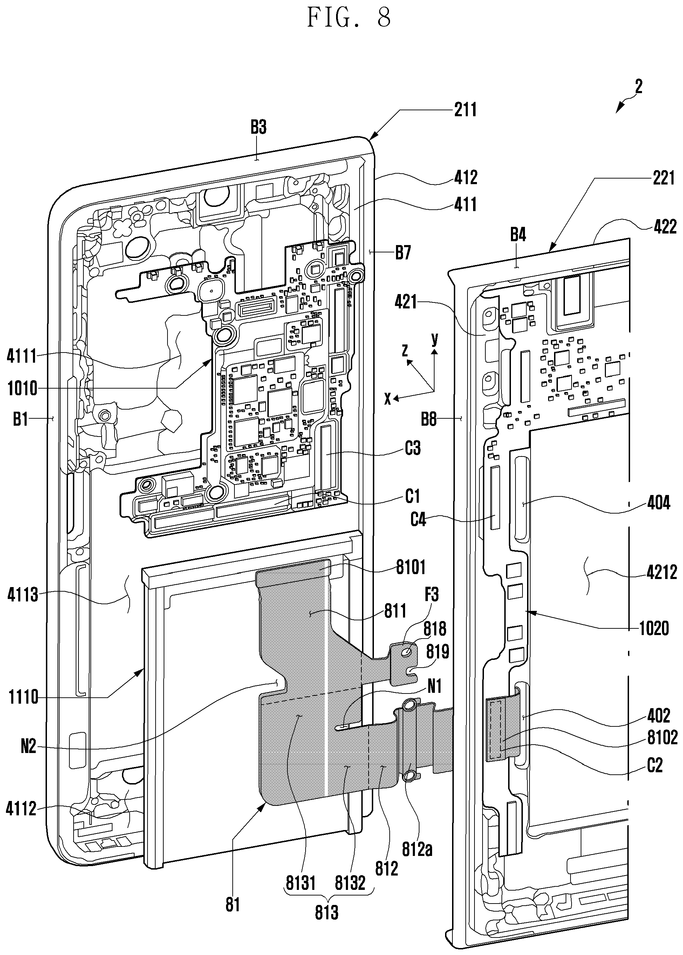

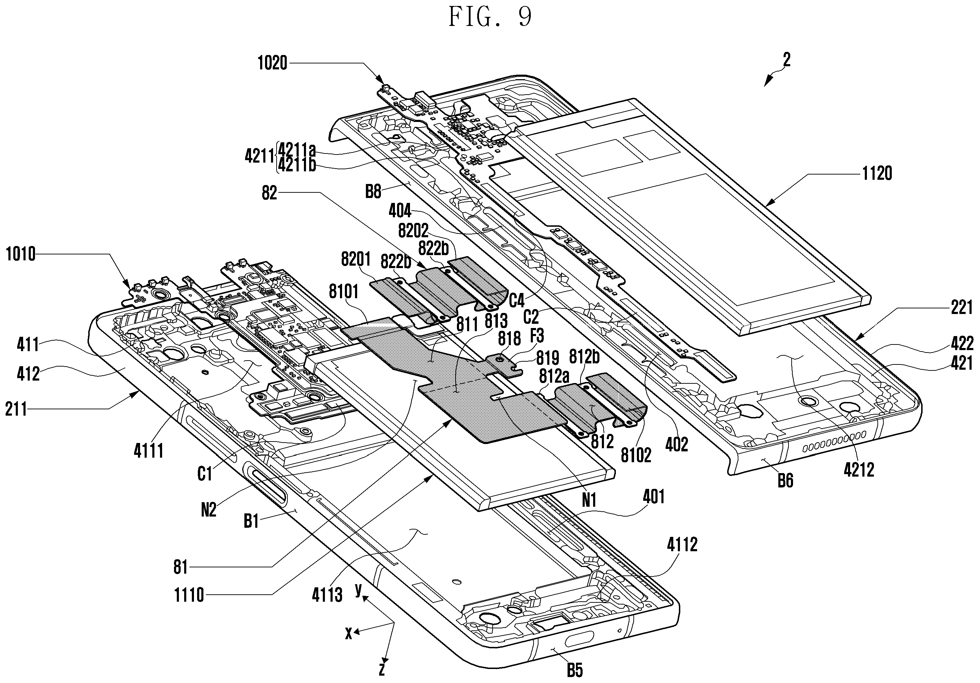

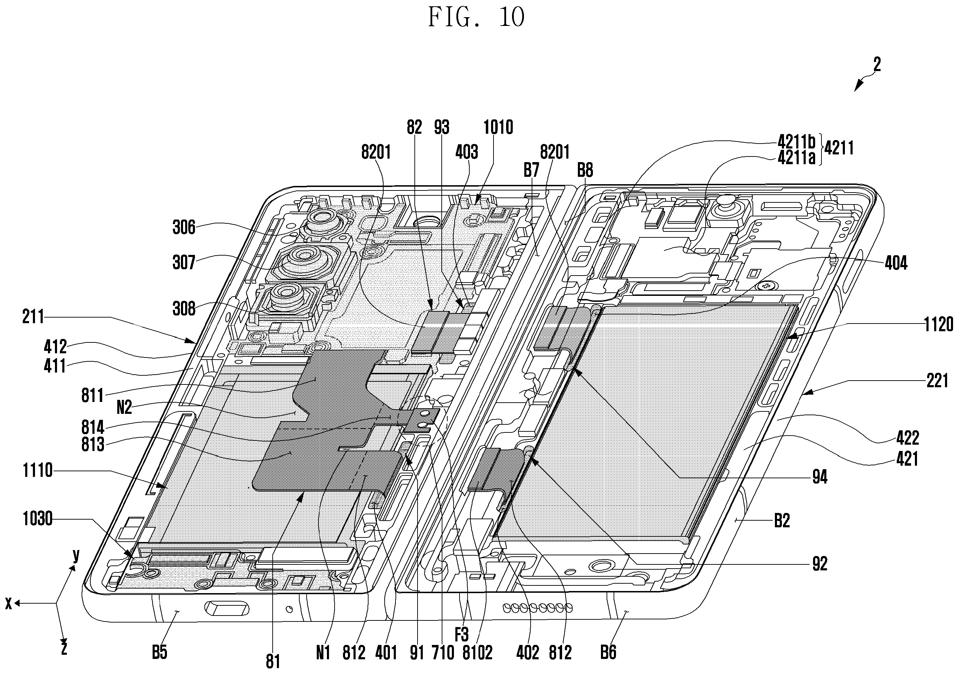

FIGS. 8 and 9 are exploded perspective views of the foldable electronic device 2 according to an embodiment of the disclosure. FIG. 10 is a perspective view of the foldable electronic device 2 in the unfolded state according to an embodiment of the disclosure. FIG. 11 is a view illustrating the foldable electronic device 2 in the unfolded state according to an embodiment of the disclosure.

With reference to FIGS. 8, 9, 10, and 11, the foldable electronic device 2 may include the first frame 211, the second frame 221, the first flexible printed circuit board 81, the second flexible printed circuit board 82, the first seal portion 91, the second seal portion 92, the third seal portion 93, the fourth seal portion 94, a first printed circuit board 1010, a second printed circuit board 1020, a third printed circuit board 1030, a first battery 1110, and/or a second battery 1120.

According to an embodiment, the first side 412 of the first frame 211 may include a seventh bezel B7 that connects one end of the third bezel B3 and one end of the fifth bezel B5. The second side 422 of the second frame 221 may include an eighth bezel B8 that connects one end of the fourth bezel B4 and one end of the sixth bezel B6. The seventh bezel B7 and the eighth bezel B8 may extend in the direction of the center line A (see FIG. 2) of the foldable electronic device 2 and be parallel to each other. In various embodiments, the seventh bezel B7 may include a portion corresponding to the first hinge housing cover 213 of FIG. 6, in which case the first hinge housing cover 213 may be omitted. In various embodiments, the eighth bezel B8 may include a portion corresponding to the second hinge housing cover 223 of FIG. 6, in which case the second hinge housing cover 223 may be omitted.

According to an embodiment, the third support area 411B (see FIG. 4) of the first support portion 411 included in the first frame 211 may include a first disposition area 4111, a second disposition area 4112, and/or a third disposition area 4113. The first disposition area 4111 may be positioned closer to the third bezel B3 than the fifth bezel B5, and the second disposition area 4112 may be positioned closer to the fifth bezel B5 than the third bezel B3. The third disposition area 4113 may be positioned between the first disposition area 4111 and the second disposition area 4112. The first printed circuit board 1010 may be disposed in the first disposition area 4111. The third printed circuit board 1030 may be disposed in the second disposition area 4112. The first battery 1110 may be disposed in the third disposition area 4113.

According to an embodiment, the first opening 401 may be provided between the third disposition area 4113 (or the first battery 1110) and the seventh bezel B7, when viewed from the top of the first cover 212 (see FIG. 2) (e.g., when viewed in the +z axis direction). The third opening 403 may be provided between the first disposition area 4111 (or the first printed circuit board 1010) and the seventh bezel B7, as viewed from the top of the first cover 212 (see FIG. 2).

According to an embodiment, the fourth support area 421B (see FIG. 4) of the second support portion 421 included in the second frame 221 may include a fourth disposition area 4211 and a fifth disposition area 4212. The fourth disposition area 4211 may include a first partial disposition area 4211a and a second partial disposition area 4211b. The first partial disposition area 4211a may be positioned closer to the fourth bezel B4 than the sixth bezel B6 and positioned at least partially between the fourth bezel B4 and the fifth disposition area 4212. The second partial disposition area 4211b may be positioned between the eighth bezel B8 and the fifth disposition area 4212. The fifth disposition area 4212 may be positioned between the second partial disposition area 4211b and the second bezel B2. The second printed circuit board 1020 may be disposed in the fourth disposition area 4211. The second printed circuit board 1020 may include a first substrate area disposed in the first portion disposition area 4211a, and a second substrate area extending from the first substrate area and disposed in the second partial disposition area 4211b. The second battery 1120 may be disposed in the fifth disposition area 4212.

According to an embodiment, the second opening 402 and/or the fourth opening 404 may be provided between the second partial disposition area 4211b (or the second substrate area disposed in the second partial disposition area 4211b of the second printed circuit board 1020) and the fifth disposition area 4212 (or the second battery 1020), as viewed from the top of the second cover 222 (see FIG. 2).

According to an embodiment, the disposition guide structure 710 between the first flexible printed circuit board 81 and the first frame 211 may be positioned between the first battery 1110 (or the third disposition area 4113) and the seventh bezel B7 when viewed from the top of the first cover 212 (see FIG. 2) (e.g., when viewed in the +z axis direction).

According to an embodiment, the first end 8101 of the first flexible printed circuit board 81 may be electrically connected with a connector (or a first element) C1 disposed on the first printed circuit board 1010. The second end 8102 of the first flexible printed circuit board 81 may be electrically connected with a connector (or a second element) C2 disposed on the second printed circuit board 1020. In embodiments including the second flexible printed circuit board 82, the third end 8201 of the second flexible printed circuit board 82 may be electrically connected with a connector C3 disposed on the first printed circuit board 1010. The fourth end 8202 of the second flexible printed circuit board 82 may be electrically connected with a connector C4 disposed on the second printed circuit board 1020.

According to an embodiment, a portion of the second area 812 of the first flexible printed circuit board 81 may be a fourth fixing portion F4 (see FIG. 11) coupled with the first seal portion 91 disposed in the first opening 401. The third area 813 of the first flexible printed circuit board 81 may connect the first area 811 of the first flexible printed circuit board 81 with a portion extending from the fourth fixing portion F4 of the second area 812 to the third area 813 of the first flexible printed circuit board 81. The third area 813 may be provided in a bent form, for example, an elbowed or angled form. The third area 813 of the first flexible printed circuit board 81 may be overlapped at least partially with the first battery 1110 when viewed from the top of the first cover 212 (see FIG. 2) (e.g., when viewed in the +z axis direction). A portion of the first area 811 and a portion of the second area 812 of the first flexible printed circuit board 81 may be overlapped with the first battery 1110 when viewed from the top of the first cover 212 (see FIG. 2). For example, a portion of the first substrate surface 81A (see FIG. 6) included in the first flexible printed circuit board 81 may face the first battery 1110.

According to an embodiment, when viewed from the top of the first cover 212 (see FIG. 2) (e.g., when viewed in the +z axis direction), the first end 8101 and the third area 813 of the first flexible printed circuit board 81 may be spaced apart from each other in a first direction (e.g., in the y axis direction) of the center line A of the foldable electronic device 2. When viewed from the top of the first cover 212 (see FIG. 2), the first end 8101 and the fourth fixing portion F4 of the first flexible printed circuit board 81 may be spaced apart from each other in a second direction perpendicular to the center line A of the foldable electronic device 2 (e.g., in the x-axis direction).

According to an embodiment, the first flexible printed circuit board 81 a first portion 8131 (see FIG. 8) and a second portion 8132 (see FIG. 8). The first portion 8131 may extend the first area 811 of the first flexible printed circuit board 81. The second portion 8132 may extend the second area 812 of the first flexible printed circuit board 81. The first portion 8131 extends the first area 811 and the second portion 8132. The second portion 8132 extends the first portion 8131 and the second area 812.

According to an embodiment, the first portion 8131 and the second portion 8132 of the third area 813 may be extended in a different direction. The first portion 8131 may be extended in a first direction (e.g., in the y-axis direction), and the second portion 8132 may be extended in a second direction (e.g. in the x-axis direction) different from the first direction.

According to an embodiment, a first direction extending the first portion 8131 of the third area 813 and a second direction extending the second portion 8132 of the third area 813 may be substantially perpendicular to each other.

According to an embodiment, the third area 813 may be provided in the form of a 90-degree elbow.

According to an embodiment, although not illustrated separately, a first direction extending the first portion 8131 of the third area 813 may be at an acute or obtuse angle to a second direction extending the second portion 8132 of the third area 813.

According to an embodiment, although not illustrated separately, the third area 813 may be provided (or formed) in a curved shape extending the first area 811 and the second area 812.

According to an embodiment, the first flexible printed circuit board 81 may include a first notch N1 and/or a second notch N2. The first notch N1 and/or the second notch N2 may reduce stress that may occur in the first flexible printed circuit board 81 due to assembly deviation (or assembly position deviation) (e.g., the extent to which figures, positions, or orientations deviate from a predetermined standard or are inaccurate when assembled). The first notch N1 and/or the second notch N2 may reduce or prevent stress concentration on at least a portion of the first flexible printed circuit board 81 due to assembly deviation. The first notch N1 and/or the second notch N2 may reduce or prevent the first flexible printed circuit board 81 from breaking due to assembly deviation. The first notch N1 and/or the second notch N2 may reduce or prevent wrinkling or crumpling of the first flexible printed circuit board 81 due to assembly deviation. Operations of disposing (or connecting) constituent elements to the foldable housing 20 may include a first operation and a second operation with respect to the first flexible printed circuit board 81. In the first operation, the third fixing portion F3 of the first flexible printed circuit board 81 may be fixed to the first support portion 411 of the first frame 211, and the fourth fixing portion F4 of the first flexible printed circuit board 81 may be fixed to the first seal portion 91 disposed in the first opening 401 of the first support portion 411. In the second operation subsequent to the first operation, the first end 8101 of the first flexible printed circuit board 81 may be connected with the connector C1 of the first printed circuit board 1010 disposed in the first frame 211. The first notch N1 and/or the second notch N2 may reduce stress that may occur in a portion of the first flexible printed circuit board 81 between the first end 8101, the third fixing portion F3, and the fourth fixing portion F4 after the second operation due to assembly deviation. The first notch N1 and/or the second notch N2 may reduce or prevent stress concentration on at least a portion of the portion between the first end 8101, the third fixing portion F3, and the fourth fixing portion F4 of the first flexible printed circuit board 81 after the second operation due to assembly deviation. The first notch N1 and/or the second notch N2 may reduce or prevent the portion between the first end 8101, the third fixing portion F3, and the fourth fixing portion F4 of the first flexible printed circuit board 81 from breaking after the second operation due to assembly deviation. The first notch N1 and/or the second notch N2 may reduce or prevent wrinkling or crumpling of the portion of the first flexible printed circuit board 81 between the first end 8101, the third fixing portion F3, and the fourth fixing portion F4 after the second operation due to assembly deviation.

According to an embodiment, the third area 813 of the first flexible printed circuit board 81 may include the first notch N1. The first notch N1 may reduce stress that may occur in the third area 813 due to assembly deviation or reduce or prevent stress from being concentrated in any portion of the third area 813. The position, number, or shape of the notches included in the third area 813 may vary without being limited to the example illustrated.

According to an embodiment, the first area 811 of the first flexible printed circuit board 81 may include the second notch N2. The second notch N2 may reduce stress that may occur in the first area 811 due to assembly deviation or reduce or prevent stress from being concentrated in any portion of the first area 811. The position, number, or shape of the notches included in the first area 811 may vary without being limited to the example illustrated.

The first flexible printed circuit board 81 may include a thickness between the first substrate surface 81A (see FIG. 4) and the second substrate surface 81B (see FIG. 4), a width between a first edge 81C (see FIG. 11) and a second edge 81D (see FIG. 11), and a length extending from the first end 8101 to the second end 8102. The first edge 81C may be closer to the third fixing portion F3 than the second edge 81D. In an embodiment, the first notch N1 may be provided on the first edge 81C, and the second notch N2 may be provided on the second edge 81D.

According to various embodiments, the second area 812 may include at least one notch.

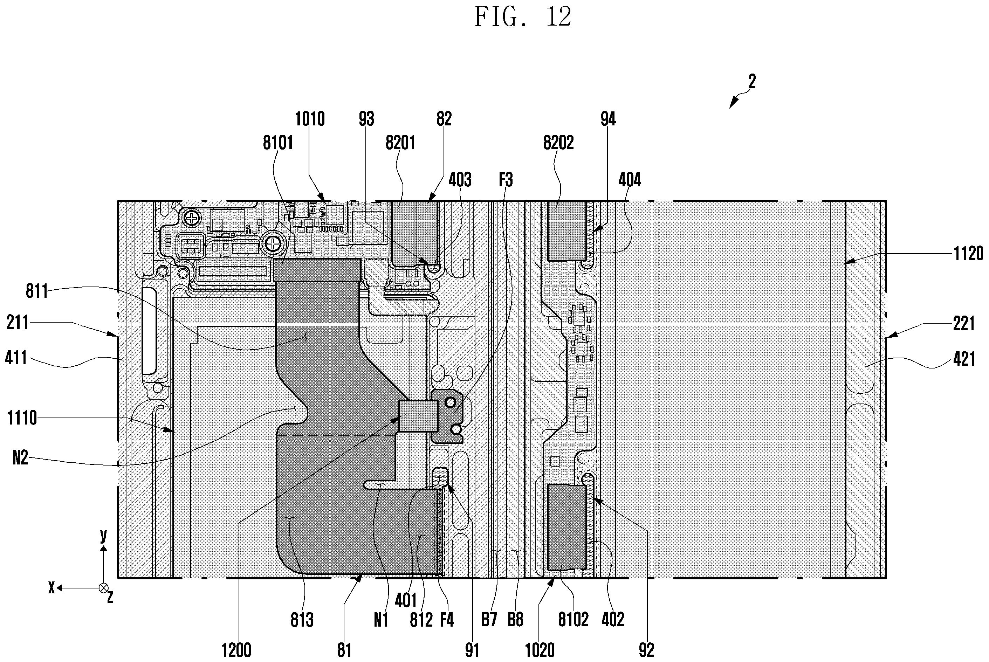

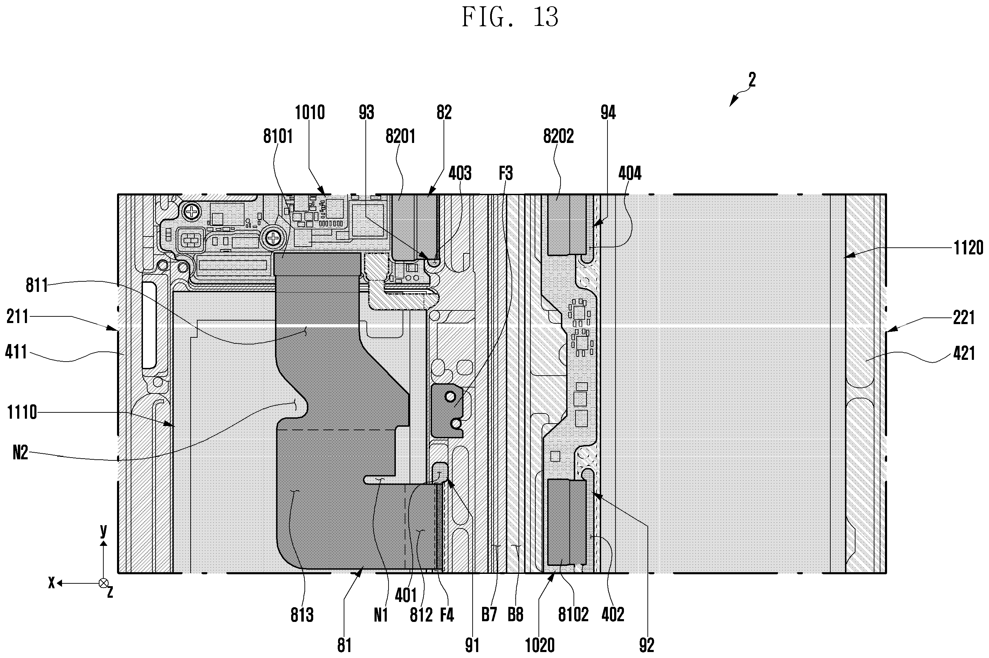

FIG. 12 is a view illustrating the foldable electronic device 2 in the unfolded state according to an embodiment of the disclosure. FIG. 13 is a view illustrating the foldable electronic device 2 that a connection member is separated.

With reference to FIGS. 12 and 13, the foldable electronic device 2 may include the first frame 211, the second frame 221, the first flexible printed circuit board 81, the second flexible printed circuit board 82, the first seal portion 91, the second seal portion 92, the third seal portion 93, the fourth seal portion 94, the first printed circuit board 1010, the second printed circuit board 1020, the third printed circuit board 1030, the first battery 1110, the second battery 1120, the third fixing portion (or the rigid portion ) F3, and/or a connection member 1200. Descriptions of some of the same components as the reference numerals shown in FIGS. 8, 9, 10, and 11 are omitted.

According an embodiment, the third fixing portion (or the rigid portion) F3 may be implemented as separate from the first flexible printed circuit board 81. The first flexible printed circuit board 81 and the third fixing portion F3 may be separated from each other. The first flexible printed circuit board 81 does not include the third fixing portion F3 and a portion extending the third fixing portion F3 compared to the example of FIG. 11.

The connection member 1200 connects the first flexible printed circuit board 81 and the third fixing potion F3. The third fixing portion F3 may be connected to the first area 811 of the first flexible printed circuit board 81 via the connection member 1200. Although not illustrated separately, the connection member 1200 may be configured to connect the third area 813 of the first flexible printed circuit board 81 and the third fixing portion F3. The connection member 1200 is configured to connect the first flexible printed circuit board 81 and the third fixing portion F3 such that a relative position between the first flexible printed circuit board 81 and the third fixing portion F3 is fixed or maintained.

According to an embodiment, the connection member 1200 may include a plate or a film.

According to an embodiment, the connection member 1200 may be a rigid plate or film.

According to an embodiment, the connection member 1200 may be flexible.

According to an embodiment, when viewed from the top of the second cover 212 (see FIG. 2), the connection member 1200 may overlap the first flexible printed circuit board 81 and the third fixing portion F3. For example, a portion of the connection member 1200 may be located between the first flexible printed circuit board 81 and the first cover 212 (see FIG. 2), and be coupled to the first flexible printed circuit board 81. For example, another portion of the connection member 1200 may be located between the third fixing portion F3 and the first cover 212 (see FIG. 2), and be coupled to the third fixing portion F3.

According to an embodiment, the connection member 1200 may be coupled with the first flexible printed circuit board 81 via an adhesive material (not shown separately) disposed between the connection member 1200 and the first flexible printed circuit board 81.

According to an embodiment, the connection member 1200 may be coupled with the third fixing portion F3 via an adhesive material (not shown separately) disposed between the connection member 1200 and the third fixing portion F3.

According to an embodiment, the connection member 1200 may be an adhesive tape or a bonding tape. The connection member 1200, for example, may include an adhesive surface (or a bonding surface), and a non-adhesive surface (or a non-bonding surface) opposite to the adhesive surface. The adhesive surface of the connection member 1200 may face the first flexible printed circuit board 81 and the third fixing portion F3, and be coupled with the first flexible printed circuit board 81 and the third fixing portion F3. The non-adhesive surface of the connection member 1200 may face the first cover 212 (see FIG. 2).

According to an embodiment, the connection member 1200 may overlap at least one element at between the first flexible printed circuit board 81 and the third fixing portion F3, when viewed from the top of the second cover 212 (see FIG. 2). For example, the connection member 1200 may overlap the first battery 1110 at between the first flexible printed circuit board 81 and the third fixing portion F3, when viewed from the top of the second cover 212 (see FIG. 2).

According to an embodiment, the adhesive surface of the connection 1200 (e.g., an adhesive tape) may be coupled to the first battery 1100 at between the first flexible printed circuit board 81 and the third fixing portion F3.

According to an example embodiment of the disclosure, the foldable electronic device 2 includes the foldable housing 20 and the flexible printed circuit board 81. The foldable housing 20 includes the first housing 21, the second housing 22, and the hinge portion H that connects the first housing 21 and the second housing 22. The flexible printed circuit board 81 electrically connects the first element (e.g., the connector C1) disposed in the first housing 21 and the second element (e.g., the connector C2) disposed in the second housing 22, and is disposed across the hinge portion H. The flexible printed circuit board 81 includes the first area 811, the second area 812, the third area 813, and the fourth area 814. The first area 811 extends from the first end 8101 electrically connected to the first element C1 and is positioned corresponding to the first housing 21. The second area 812 extends from the second end 8102 electrically connected to the second element C2, and may be disposed across the hinge portion H. The third area 813 is positioned corresponding to the first housing 21 and may connect the first area 811 and the second area 812. The third area 813 may include the first portion of the first area 811 extending in the first direction, and the second portion of the second area 812 extending in the second direction different from the first direction and connected to the first portion. The fourth area 814 extends from the first area 811 or the third area 813 and may be fixed to the first housing 21. The flexible printed circuit board 81 is therefore stably connected across the hinge portion H and supported by the hinge portion H to allow for a stable connection during assembly process. In addition, the flexible printed circuit board 81 may be disposed in a designated position by means of the fourth area 814. A position of the flexible printed circuit board 81 with respect to the first housing 21 may be preferentially (or primarily) determined by means of the fixation of the fourth area 814 which further enables the flexible printed circuit board 81 to be stably positioned in response to shocks or shaking that may occur during an assembly process.

According to an example embodiment of the disclosure, the first housing 21 may include the first support area 411A, the third support area 411B provided opposite to the first support area 411A, and the first opening 401 that penetrates the first support area 411A and the third support area 411B. The second housing 22 may include the second support area 421A, the fourth support area 421B provided opposite to the second support area 421A, and the second opening 402 that penetrates the second support area 421A and the fourth support area 421B. In the folded state of the foldable housing 20, the first support area 411A and the second support area 421A may face each other, and the third support area 411B and the fourth support area 421B may be directed in opposite directions. The first element C1 may be disposed in the third support area 411B, and the second element C2 may be disposed in the fourth support area 421B. The second area 812 of the flexible printed circuit board 81 may penetrate the first opening 401 and the second opening 402. The openings 401, 402 allow for a stable connection of the second area 812 of the flexible printed circuit board 81 across the hinge portion H. The foldable electronic device 2 may further include the first seal portion 91 disposed in the first opening 401 and the second seal portion 92 disposed in the second opening 402. The second area 812 of the flexible printed circuit board 81 may penetrate the first seal portion 91 and the second seal portion 92. The seal portions 91, 92 may reduce or prevent moisture introduced inside the foldable electronic device 2 from the outside from flowing (or moving) through the openings 401, 402. In addition, the second area 812 of the flexible printed circuit board 81 may be further stably connected by contribution of the seal portions 91, 92.

According to an example embodiment of the disclosure, the flexible printed circuit board 81 may further include the first notch N1 provided in the third area 813. The first notch N1 may reduce stress that may occur in the flexible printed circuit board 81 due to assembly deviation (or assembly position deviation) (e.g., the extent to which figures, positions, or orientations deviate from a predetermined standard or are inaccurate when assembled). The first notch N1 may reduce or prevent stress concentration on at least a portion of the flexible printed circuit board 81 and reduce or prevent braking, wrinkling or crumpling of the flexible printed circuit board 81 due to assembly deviation.

According to an example embodiment of the disclosure, the flexible printed circuit board 81 may further include the second notch N2 provided in the first area 811. The second notch N2 may further reduce stress that may occur in the flexible printed circuit board 81 due to assembly deviation (or assembly position deviation) (e.g., the extent to which figures, positions, or orientations deviate from a predetermined standard or are inaccurate when assembled) and may reduce or prevent stress concentration on at least a portion of the flexible printed circuit board 81 due to assembly deviation. The second notch N2 may reduce or prevent the flexible printed circuit board 81 from breaking, wrinkling or crumpling of the flexible printed circuit board 81 due to assembly deviation.

According to an example embodiment of the disclosure, the fourth area 814 of the flexible printed circuit board 81 may further include one or more openings 818 and 819. The first housing 21 may include one or more protrusions P1, P2 inserted into the one or more openings 818 and 819. This may enable the flexible printed circuit board 81 to be stably positioned with respect to the first opening 401 in response to shocks or shaking that may occur during an assembly process.

According to an example embodiment of the disclosure, the portion F3 of the fourth area 814 of the flexible printed circuit board 81 fixed to the first housing 21 may be rigidly constituted. This may secure the flexible printed circuit board 81 to be stably positioned during assembly process.

According to an example embodiment of the disclosure, the fourth area 814 of the flexible printed circuit board substrate 81 may include the reinforcing portion. The reinforcing portion may further secure the flexible printed circuit board 81 to be stably positioned during the assembly process.

According to an example embodiment of the disclosure, the third area 813 of the flexible printed circuit board 81 may be provided in the form of a 90-degree elbow.

According to an example embodiment of the disclosure, the second area 812 of the flexible printed circuit board 81 may further include the first fixing portion F1 coupled to the hinge portion H corresponding to the first housing 21 and the second fixing portion F2 coupled to the hinge portion H corresponding to the second housing 22. This may further secure the flexible printed circuit board 81 to be stably positioned, in particular, during the assembly process.

According to an example embodiment of the disclosure, the hinge portion H may include the hinge module 5A, and the first plate 71 and the second plate 72 coupled to the hinge module 5A. The hinge module 5A may include the first bracket 51A fixed to the first housing 21, the second bracket 52A fixed to the second housing 22, and the bracket connector 53A that connects the first bracket 51A and the second bracket 52A. The first plate 71 may be coupled with the bracket connector 53A corresponding to the first housing 21, and the second plate 72 may be coupled with the bracket connector 53A corresponding to the second housing 22. In the folded state of the foldable housing 20, the first surface 71A of the first plate 71 and the second surface 72A of the second plate 72 may face each other. In the unfolded state of the foldable housing 20, an angle formed by the first surface 71A and the second surface 72A may be 180 degrees. In the unfolded state, even when an external force (e.g., an external pressure such as a touch input using a user's finger or a touch input using an electronic pen but not restricted thereto) is applied to an area corresponding to the hinge portion H, the area corresponding to the hinge portion H, e.g. the third display area, may be maintained flat by the support of the first plate 71 and the second plate 72.

According to an embodiment, the bracket connector 53A of the first hinge module 5A may include a center plate 54A aligned with the center line A of the foldable electronic device 2. The center plate 54A may reduce or prevent a sagging phenomenon or a creep phenomenon of a portion of the area that corresponds to a gap between the first surface 71A of the first plate 71 and the second surface 72A of the second plate 72 in the unfolded state of the foldable electronic device 2.

According to an example embodiment of the disclosure, the foldable electronic device 2 may further include the battery 1110 disposed in the first housing 21. The flexible printed circuit board 81 may include the first substrate surface 81A and the second substrate surface 81B disposed opposite to the first substrate surface 81A. A portion of the first substrate surface 81A may face the battery 1110.

According to an example embodiment of the disclosure, the foldable electronic device 2 may further include the flexible display module (e.g., the first display module 24 in FIG. 2) disposed in the foldable housing 20. The flexible display module 24 may include the first display area ①, the second display area ②, and the third display area ③. The first display area ① may be disposed in the first housing 21. The second display area ② may be disposed in the second housing 22. The third display area ③ may connect the first display area ① and the second display area ②, and may be positioned corresponding to the hinge portion H. The hinge portion H may support the third display area ③. For example, in case that an external force (e.g., an external pressure such as a touch input using a user's finger or a touch input using an electronic pen) is applied to the third display area ③, the hinge portion H reduces a sagging phenomenon of the third display area ③ so that the third display area ③ remains flat. In the unfolded state, in case that an external impact such as a fall is applied, the hinge portion H is constituted to reduce the influence of the external impact on the third display area ③. Thus, the hinge portion H supports the third display area ③ so that the third display area ③ may be disposed flat without sagging, thereby reducing a crease phenomenon.

According to an example embodiment of the disclosure, a foldable electronic device 2 includes a foldable housing 20 and a flexible printed circuit board 81. The foldable housing 20 includes a first housing 21, a second housing 22, and a hinge portion H connecting the first housing 21 and the second housing 22. The flexible printed circuit board 81 electrically connects a first element C1 disposed in the first housing 21 and a second element C2 disposed in the second housing 22. The flexible printed circuit board 81 is disposed across the hinge portion H. The flexible printed circuit board 81 includes a first area 811, a second area 812, a third area 813, and a rigid portion F3. The first area 811 includes a first connector end 8101 electrically connected to the first element C1. The second area 812 includes a second connector end 8102 electrically connected to the second element C2. The second area 812 is disposed across the hinge portion H. The third area 813 is disposed between the first area 811 and the second area 812. The third area 813 includes a first portion 8131 extending in a first direction and a second portion 8132 extending in a second direction to the second area 812. The second direction is different from the first direction. The first area 811 and the third area 813 are disposed in the first housing 21. The rigid portion F3 is configured to connect the first area 811 or the third area 813 extending toward the hinge portion H to the first housing 21.

According to an example embodiment of the disclosure, at least one signal line included in the flexible printed circuit board 81 may be not disposed in the rigid portion F3.

According to an example embodiment of the disclosure, the first housing 21 may include a first support area 411A, a third support area 411B provided opposite to the first support area 411A, and a first opening 401 configured to penetrate the first support area 411A and the third support area 411B. The second housing 22 may include a second support area 421A, a fourth support area 421B provided opposite to the second support area 421A, and a second opening 402 configured to penetrate the second support area 421A and the fourth support area 421B. In a folded state of the foldable housing 20, the first support area 411A and the second support area 421A may face each other and the third support area 411B and the fourth support area 421B may be directed in opposite directions from each other. The first element C1 may be disposed on the third support area 411B. The second element C2 may be disposed on the fourth support area 421B. The second area 812 of the flexible printed circuit board 81 may penetrate the first opening 401 and the second opening 402. The rigid portion F3 may be fixed to the third support area 411B.

According to an example embodiment of the disclosure, the foldable electronic device 2 may further include a first seal member 91 disposed in the first opening 401 and a second seal member 92 disposed in the second opening 402. The second area 812 of the flexible printed circuit board 81 may be fixed to the first housing 21 via the first seal member 91. The second area 812 of the flexible printed circuit board 81 may be fixed to the second housing 22 via the second seam member 92. The rigid portion F3 and the first opening 401 may be disposed in a direction of a folding axis A of the foldable electronic device 2.

According to an example embodiment of the disclosure, the foldable electronic device 2 may further include a battery 1110 disposed on the third support area 411B. The third area 813 of the flexible printed circuit board 81 may overlap the battery 1110. The rigid portion F3 may be disposed on a fixing area between the battery 1110 and the second housing 22 with reference to an unfolded state of the foldable electronic device 2.

According to an example embodiment of the disclosure, the foldable electronic device 2 may further include another flexible printed circuit board 82 electrically connecting a third element C3 disposed in the first housing 21 and a fourth element C4 disposed in the second housing 22. The other flexible printed circuit board 82 may be disposed across the hinge portion H. The first housing 21 may include a third opening 403 configured to penetrate the first support area 411A and the third support area 411B. The second housing 22 may include a fourth opening 404 configured to penetrate the second support area 421A and the fourth support area 421B. The other flexible printed circuit board 82 may penetrate the third opening 403 and the fourth opening 404. The rigid portion F3 may be fixed on a fixing area of the third support area 411B located between the first opening 401 and the third opening 403.

According to an example embodiment of the disclosure, the flexible printed circuit board 81 may include a first edge 81C and a second edge 81D. The flexible printed circuit board 81 may have a width between the first edge 81C and the second edge 81D. The first edge 81C may be closer to the rigid portion F3 than the second edge 81D. The flexible printed circuit board 81 may further include a first notch N1 provided in the third area 813. The first notch N1 may be formed at the first edge 81C.

According to an example embodiment of the disclosure, the flexible printed circuit board 81 may further include a second notch N2 provided in the first area 811. The second notch N2 may be formed at the second edge 81D.

According to an example embodiment of the disclosure, the rigid portion F3 of the flexible printed circuit board 81 may further include one or more openings 818 and 819. The first housing 21 may include one or more protrusions P1 and P2 inserted into the one or more openings 818 and 819.

According to an example embodiment of the disclosure, the flexible printed circuit board 81 may include a fourth area 814 extending from the first area 811 or the third area 813. The rigid portion F3 may include a reinforcing portion and a portion of the fourth area 814 where the reinforcing portion is disposed.

According to an example embodiment of the disclosure, the rigid portion F3 may be connected to the first area 811 or the third area 813 via a connection member 1200.

According to an example embodiment of the disclosure, the third area 813 of the flexible printed circuit board 81 may be provided in a form of a 90-degree elbow.

According to an example embodiment of the disclosure, the second area 812 of the flexible printed circuit board 81 may further include a first fixing portion F1 coupled to the hinge portion H corresponding to the first housing 21 and a second fixing portion F2 coupled to the hinge portion H corresponding to the second housing 22. The first fixing portion F1 and/or the second fixing portion F2 may be rigid.

According to an example embodiment of the disclosure, the hinge portion H may include a hinge module 5A, and a first plate 71 and a second plate 72 coupled to the hinge module 5A. The hinge module 5A may include a first bracket 51A fixed to the first housing 21, a second bracket 52A fixed to the second housing 22, and a bracket connector 53A configured to connect the first bracket 51A and the second bracket 52A. The first plate 71 may be coupled with the bracket connector 53A corresponding to the first housing 21. The second plate 72 may be coupled with the bracket connector 53A corresponding to the second housing 22. A first surface 71A of the first plate 71 and a second surface 72A of the second plate 72 may faces each other in the folded state of the foldable housing 20. An angle formed by the first surface 71A and the second surface 72A in an unfolded state of the foldable housing 20 may be 180 degrees. The first fixing portion F1 of the flexible printed circuit board 81 may be coupled to the first plate 71. The second fixing portion F2 of the flexible printed circuit board 81 may be coupled to the second plate 72.

According to an example embodiment of the disclosure, the foldable electronic device 2 may further include a flexible display module 24 disposed in the foldable housing 20. The flexible display module 24 may include a first display area ① disposed in the first housing 21, a second display area ② disposed in the second housing 22, and a third display area ③ positioned corresponding to the hinge portion H and extending the first display area ① and the second display area ②.

The embodiments of the disclosure disclosed in the disclosure and illustrated in the drawings are provided as particular examples for more easily explaining the technical contents according to the disclosure and helping understand the disclosure, but not intended to limit the scope of the disclosure. Accordingly, the scope of the various embodiments of the disclosure should be interpreted as including alterations or modifications in addition to the disclosed embodiments. Additionally, it will be understood that any embodiment(s) described herein may be used in conjunction with any other embodiment(s) described herein.

## Claims

1. A foldable electronic device comprising:
a foldable housing (20) comprising a first housing (21), a second housing (22), and a hinge portion (H) connecting the first housing (21) and the second housing (22); and
a flexible printed circuit board (81) electrically connecting a first element (C1) disposed in the first housing (21) and a second element (C2) disposed in the second housing (22), the flexible printed circuit board (81) being disposed across the hinge portion (H),
wherein the flexible printed circuit board (81) comprises:
a first area (811) including a first connector end (8101) electrically connected to the first element (C1);
a second area (812) including a second connector end (8102) electrically connected to the second element (C2), the second area (812) being disposed across the hinge portion (H);
a third area (813) disposed between the first area (811) and the second area (812), the third area (813) comprising a first portion (8131) extending in a first direction and a second portion (8132) extending in a second direction to the second area (812), the second direction being different from the first direction, wherein the first area (811) and the third area (813) are disposed in the first housing (21);
**characterized in that**,
the flexible printed circuit board (81) further comprises a fourth area (814) spaced apart from the second area (812) and extending from the first area (811) or the third area (813) toward the hinge portion (H), the fourth area (814) including a rigid portion (F3) connected to the first housing (21).

2. The foldable electronic device of claim 1, wherein at least one signal line included in the flexible printed circuit board (81) is not disposed in the rigid portion (F3).

3. The foldable electronic device of claim 1 or 2, wherein the first housing (21) comprises a first support area (411A), a third support area (411B) provided opposite to the first support area (411A), and a first opening (401) configured to penetrate the first support area (411A) and the third support area (411B),
wherein the second housing (22) comprises a second support area (421A), a fourth support area (421B) provided opposite to the second support area (421A), and a second opening (402) configured to penetrate the second support area (421A) and the fourth support area (421B),
wherein, in a folded state of the foldable housing (20), the first support area (411A) and the second support area (421A) face each other and the third support area (411B) and the fourth support area (421B) are directed in opposite directions from each other,
wherein the first element (C1) is disposed on the third support area (411B) and the second element (C2) is disposed on the fourth support area (421B),
wherein the second area (812) of the flexible printed circuit board (81) penetrates the first opening (401) and the second opening (402), and
wherein the rigid portion (F3) is fixed to the third support area (411B).

4. The foldable electronic device of claim 3, wherein the foldable electronic device (2) further comprises a first seal member (91) disposed in the first opening (401) and a second seal member (92) disposed in the second opening (402),
wherein the second area (812) of the flexible printed circuit board (81) is fixed to the first housing (21) via the first seal member (91),
wherein the second area (812) of the flexible printed circuit board (81) is fixed to the second housing (22) via the second seal member (92), and
wherein the rigid portion (F3) and the first opening (401) are disposed in a direction of a folding axis (A) of the foldable electronic device.

5. The foldable electronic device of claim 3 or 4, further comprises a battery (1110) disposed on the third support area (411B),
wherein the third area (813) of the flexible printed circuit board (81) overlaps the battery (1110), and
wherein the rigid portion (F3) is disposed on a fixing area between the battery (1110) and the second housing (22) with reference to an unfolded state of the foldable electronic device.

6. The foldable electronic device of any one of claims 3 to 5, further comprises another flexible printed circuit board (82) electrically connecting a third element (C3) disposed in the first housing (21) and a fourth element (C4) disposed in the second housing (22), the other flexible printed circuit board (82) being disposed across the hinge portion (H),
wherein the first housing (21) includes a third opening (403) configured to penetrate the first support area (411A) and the third support area (411B),
wherein the second housing (22) includes a fourth opening (404) configured to penetrate the second support area (421A) and the fourth support area (421B),
wherein the other flexible printed circuit board (82) penetrates the third opening (403) and the fourth opening (404), and
wherein the rigid portion (F3) is fixed on a fixing area of the third support area (411B) located between the first opening (401) and the third opening (403).

7. The foldable electronic device of any one of claims 1 to 6,
wherein the flexible printed circuit board (81) includes a first edge (81C) and a second edge (81D), the flexible printed circuit board (81) having a width between the first edge (81C) and the second edge (81D),
wherein the first edge (81C) is closer to the rigid portion (F3) than the second edge (81D), and
wherein the flexible printed circuit board (81) further comprises a first notch (N1) provided in the third area (813), the first notch (N1) formed at the first edge (81C).

8. The foldable electronic device of claim 7, wherein the flexible printed circuit board (81) further comprises a second notch (N2) provided in the first area (811), the second notch (N2) formed at the second edge (81D).

9. The foldable electronic device of any one of claims 1 to 8, wherein the rigid portion (F3) of the flexible printed circuit board (81) further comprises one or more openings (818, 819), and the first housing (21) comprises one or more protrusions (P1, P2) inserted into the one or more openings (818, 819).

10. The foldable electronic device of any one of claims 1 to 9,
wherein the rigid portion (F3) includes a reinforcing portion.

11. The foldable electronic device of any one of claims 1 to 9, wherein the rigid portion (F3) is connected to the first area (811) or the third area (813) via a connection member (1200).

12. The foldable electronic device of any one of claims 1 to 11, wherein the third area (813) of the flexible printed circuit board (81) is provided in a form of a 90-degree elbow.

13. The foldable electronic device of any one of claims 1 to 12, wherein the second area (812) of the flexible printed circuit board (81) further comprises a first fixing portion (F1) coupled to the hinge portion (H) corresponding to the first housing (21) and a second fixing portion (F2) coupled to the hinge portion (H) corresponding to the second housing (22), and
wherein the first fixing portion (F1) and/or the second fixing portion (F2) are rigid.

14. The foldable electronic device of claim 13, wherein the hinge portion (H) comprises a hinge module (5A), and a first plate (71) and a second plate (72) coupled to the hinge module (5A),
wherein the hinge module (5A) comprises a first bracket (51A) fixed to the first housing (21), a second bracket (52A) fixed to the second housing (22), and a bracket connector (53A) configured to connect the first bracket (51A) and the second bracket (52A),
wherein the first plate (71) is coupled with the bracket connector (53A) corresponding to the first housing (21) and the second plate (72) is coupled with the bracket connector (53A) corresponding to the second housing (22),
wherein a first surface (71A) of the first plate (71) and a second surface (72A) of the second plate (72) face each other in the folded state of the foldable housing (20),
wherein an angle formed by the first surface (71A) and the second surface (72A) in an unfolded state of the foldable housing (20) is 180 degrees,
wherein the first fixing portion (F1) of the flexible printed circuit board (81) is coupled to the first plate (71), and
wherein the second fixing portion (F2) of the flexible printed circuit board (81) is coupled to the second plate (72).

15. The foldable electronic device of any one of claims 1 to 14, further comprising a flexible display module (24) disposed in the foldable housing (20),
wherein the flexible display module (24) comprises:
a first display area (①) disposed in the first housing (21);
a second display area (②) disposed in the second housing (22); and
a third display area (③) positioned corresponding to the hinge portion (H) and extending the first display area (①) and the second display area (②).

## Patentansprüche

1. Faltbares elektronisches Gerät, umfassend:
ein faltbares Gehäuse (20), das ein erstes Gehäuse (21), ein zweites Gehäuse (22) und einen Scharnierabschnitt (H), der das erste Gehäuse (21) und das zweite Gehäuse (22) verbindet, umfasst; und
eine flexible Leiterplatte (81), die ein erstes Element (C1), das in dem ersten Gehäuse (21) angeordnet ist, und ein zweites Element (C2), das in dem zweiten Gehäuse (22) angeordnet ist, elektrisch verbindet, wobei die flexible Leiterplatte (81) über den Scharnierabschnitt (H) angeordnet ist,
wobei die flexible Leiterplatte (81) Folgendes umfasst:
einen ersten Bereich (811) mit einem ersten Verbinder-Ende (8101), das elektrisch mit dem ersten Element (C1) verbunden ist;
einen zweiten Bereich (812) mit einem zweiten Verbinder-Ende (8102), das elektrisch mit dem zweiten Element (C2) verbunden ist, wobei der zweite Bereich (812) über den Scharnierabschnitt (H) angeordnet ist;
einen dritten Bereich (813), der zwischen dem ersten Bereich (811) und dem zweiten Bereich (812) angeordnet ist, wobei der dritte Bereich (813) einen ersten Abschnitt (8131), der sich in einer ersten Richtung erstreckt, und einen zweiten Abschnitt (8132) umfasst, der sich in einer zweiten Richtung zum zweiten Bereich (812) erstreckt, wobei die zweite Richtung von der ersten Richtung verschieden ist, wobei der erste Bereich (811) und der dritte Bereich (813) im ersten Gehäuse (21) angeordnet sind;
**dadurch gekennzeichnet, dass**
die flexible Leiterplatte (81) ferner einen vierten Bereich (814) umfasst, der von dem zweiten Bereich (812) beabstandet ist und sich von dem ersten Bereich (811) oder dem dritten Bereich (813) in Richtung des Scharnierabschnitts (H) erstreckt, wobei der vierte Bereich (814) einen starren Abschnitt (F3) umfasst, der mit dem ersten Gehäuse (21) verbunden ist.

2. Faltbares elektronisches Gerät nach Anspruch 1, wobei mindestens eine in der flexiblen Leiterplatte (81) enthaltene Signalleitung nicht in dem starren Abschnitt (F3) angeordnet ist.

3. Faltbares elektronisches Gerät nach Anspruch 1 oder 2, wobei das erste Gehäuse (21) einen ersten Stützbereich (411A), einen dritten Stützbereich (411B), der gegenüber dem ersten Stützbereich (411A) vorgesehen ist, und eine erste Öffnung (401) umfasst, die so konfiguriert ist, dass sie den ersten Stützbereich (411A) und den dritten Stützbereich (411B) durchdringt,
wobei das zweite Gehäuse (22) einen zweiten Stützbereich (421A), einen vierten Stützbereich (421B), der gegenüber dem zweiten Stützbereich (421A) vorgesehen ist, und eine zweite Öffnung (402) umfasst, die so konfiguriert ist, dass sie den zweiten Stützbereich (421A) und den vierten Stützbereich (421B) durchdringt,
wobei in einem gefalteten Zustand des faltbaren Gehäuses (20) der erste Stützbereich (411A) und der zweite Stützbereich (421A) einander gegenüberliegen, während der dritte Stützbereich (411B) und der vierte Stützbereich (421B) in entgegengesetzte Richtungen voneinander ausgerichtet sind,
wobei das erste Element (C1) auf dem dritten Stützbereich (411B) und das zweite Element (C2) auf dem vierten Stützbereich (421B) angeordnet ist,
wobei der zweite Bereich (812) der flexiblen Leiterplatte (81) die erste Öffnung (401) und die zweite Öffnung (402) durchdringt, und
wobei der starre Abschnitt (F3) an dem dritten Stützbereich (411B) befestigt ist.

4. Faltbares elektronisches Gerät nach Anspruch 3, wobei das faltbare elektronische Gerät (2) ferner ein erstes Dichtungselement (91), das in der ersten Öffnung (401) angeordnet ist, und ein zweites Dichtungselement (92) umfasst, das in der zweiten Öffnung (402) angeordnet ist,
wobei der zweite Bereich (812) der flexiblen Leiterplatte (81) über das erste Dichtungselement (91) am ersten Gehäuse (21) befestigt ist,
wobei der zweite Bereich (812) der flexiblen Leiterplatte (81) über das zweite Dichtungselement (92) am zweiten Gehäuse (22) befestigt ist, und
wobei der starre Abschnitt (F3) und die erste Öffnung (401) in einer Richtung einer Falt-Achse (A) des faltbaren elektronischen Geräts angeordnet sind.

5. Faltbares elektronisches Gerät nach Anspruch 3 oder 4, umfassend ferner eine Batterie (1110), die auf dem dritten Stützbereich (411B) angeordnet ist,
wobei der dritte Bereich (813) der flexiblen Leiterplatte (81) die Batterie (1110) überlappt, und
wobei der starre Abschnitt (F3) in Bezug auf einen entfalteten Zustand des faltbaren elektronischen Geräts auf einem Befestigungsbereich zwischen der Batterie (1110) und dem zweiten Gehäuse (22) angeordnet ist.

6. Faltbares elektronisches Gerät nach einem der Ansprüche 3 bis 5, umfassend ferner eine weitere flexible Leiterplatte (82), die ein drittes Element (C3), das im ersten Gehäuse (21) angeordnet ist, und ein viertes Element (C4), das im zweiten Gehäuse (22) angeordnet ist, elektrisch verbindet, wobei die weitere flexible Leiterplatte (82) über den Scharnierabschnitt (H) angeordnet ist,
wobei das erste Gehäuse (21) eine dritte Öffnung (403) aufweist, die so konfiguriert ist, dass sie den ersten Stützbereich (411A) und den dritten Stützbereich (411B) durchdringt,
wobei das zweite Gehäuse (22) eine vierte Öffnung (404) aufweist, die so konfiguriert ist, dass sie den zweiten Stützbereich (421A) und den vierten Stützbereich (421B) durchdringt,
wobei die weitere flexible Leiterplatte (82) die dritte Öffnung (403) und die vierte Öffnung (404) durchdringt, und
wobei der starre Abschnitt (F3) an einem Befestigungsbereich des dritten Stützbereichs (411B) befestigt ist, der sich zwischen der ersten Öffnung (401) und der dritten Öffnung (403) befindet.

7. Faltbares elektronisches Gerät nach einem der Ansprüche 1 bis 6,
wobei die flexible Leiterplatte (81) eine erste Kante (81C) und eine zweite Kante (81D) umfasst, wobei die flexible Leiterplatte (81) eine Breite zwischen der ersten Kante (81C) und der zweiten Kante (81D) aufweist,
wobei die erste Kante (81C) näher an dem starren Abschnitt (F3) liegt als die zweite Kante (81D), und
wobei die flexible Leiterplatte (81) ferner eine erste Kerbe (N1) umfasst, die in dem dritten Bereich (813) vorgesehen ist, wobei die erste Kerbe (N1) an der ersten Kante (81C) ausgebildet ist.

8. Faltbares elektronisches Gerät nach Anspruch 7, wobei die flexible Leiterplatte (81) ferner eine zweite Kerbe (N2) umfasst, die im ersten Bereich (811) vorgesehen ist, wobei die zweite Kerbe (N2) an der zweiten Kante (81D) ausgebildet ist.

9. Faltbares elektronisches Gerät nach einem der Ansprüche 1 bis 8, wobei der starre Abschnitt (F3) der flexiblen Leiterplatte (81) ferner eine oder mehrere Öffnungen (818, 819) und das erste Gehäuse (21) einen oder mehrere Vorsprünge (P1, P2) umfasst, die in die eine oder die mehreren Öffnungen (818, 819) eingeführt sind.

10. Faltbares elektronisches Gerät nach einem der Ansprüche 1 bis 9,
wobei der starre Abschnitt (F3) einen Verstärkungsabschnitt umfasst.

11. Faltbares elektronisches Gerät nach einem der Ansprüche 1 bis 9, wobei der starre Abschnitt (F3) über ein Verbindungselement (1200) mit dem ersten Bereich (811) oder dem dritten Bereich (813) verbunden ist.

12. Faltbares elektronisches Gerät nach einem der Ansprüche 1 bis 11, wobei der dritte Bereich (813) der flexiblen Leiterplatte (81) in Form eines 90-Grad-Winkelstücks vorgesehen ist.

13. Faltbares elektronisches Gerät nach einem der Ansprüche 1 bis 12, wobei der zweite Bereich (812) der flexiblen Leiterplatte (81) ferner einen ersten Befestigungsabschnitt (F1), der mit dem Scharnierabschnitt (H) entsprechend dem ersten Gehäuse (21) verbunden ist, und einen zweiten Befestigungsabschnitt (F2) umfasst, der mit dem Scharnierabschnitt (H) entsprechend dem zweiten Gehäuse (22) verbunden ist, und wobei der erste Befestigungsabschnitt (F1) und/oder der zweite Befestigungsabschnitt (F2) starr sind.

14. Faltbares elektronisches Gerät nach Anspruch 13, wobei der Scharnierabschnitt (H) ein Scharniermodul (5A) sowie eine erste Platte (71) und eine zweite Platte (72), die mit dem Scharniermodul (5A) gekoppelt sind, umfasst,
wobei das Scharniermodul (5A) eine erste Halterung (51A), die an dem ersten Gehäuse (21) befestigt ist, eine zweite Halterung (52A), das am zweiten Gehäuse (22) befestigt ist, und einen Halterungsverbinder (53A) umfasst, der so konfiguriert ist, dass er die erste Halterung (51A) und die zweite Halterung (52A) verbindet,
wobei die erste Platte (71) mit dem Halterungsverbinder (53A) entsprechend dem ersten Gehäuse (21) und die zweite Platte (72) mit dem Halterungsverbinder (53A) entsprechend dem zweiten Gehäuse (22) gekoppelt ist,
wobei eine erste Oberfläche (71A) der ersten Platte (71) und eine zweite Oberfläche (72A) der zweiten Platte (72) im gefalteten Zustand des faltbaren Gehäuses (20) einander gegenüberliegen,
wobei ein durch die erste Oberfläche (71A) und die zweite Oberfläche (72A) in einem entfalteten Zustand des faltbaren Gehäuses (20) gebildeter Winkel 180 Grad beträgt,
wobei der erste Befestigungsabschnitt (F1) der flexiblen Leiterplatte (81) mit der ersten Platte (71) gekoppelt ist, und
wobei der zweite Befestigungsabschnitt (F2) der flexiblen Leiterplatte (81) mit der zweiten Platte (72) gekoppelt ist.

15. Faltbares elektronisches Gerät nach einem der Ansprüche 1 bis 14, umfassend ferner ein flexibles Anzeigemodul (24), das in dem faltbaren Gehäuse (20) angeordnet ist,
wobei das flexible Anzeigemodul (24) Folgendes umfasst:
einen ersten Anzeigebereich (①), der in dem ersten Gehäuse (21) angeordnet ist;
einen zweiten Anzeigebereich (②), der in dem zweiten Gehäuse (22) angeordnet ist; und
einen dritten Anzeigebereich (③), der entsprechend dem Scharnierabschnitt (H) positioniert ist und den ersten Anzeigebereich (①) und den zweiten Anzeigebereich (②) erweitert.

## Revendications

1. Dispositif électronique pliable comprenant :
un boîtier pliable (20) comprenant un premier boîtier (21), un second boîtier (22), et une partie de charnière (H) reliant le premier boîtier (21) et le second boîtier (22) ; et
une carte de circuit imprimé flexible (81) reliant électriquement un premier élément (C1) disposé dans le premier boîtier (21) et un deuxième élément (C2) disposé dans le second boîtier (22), la carte de circuit imprimé flexible (81) étant disposée à travers la partie de charnière (H),
dans lequel la carte de circuit imprimé flexible (81) comprend :
une première zone (811) comportant une première extrémité de connecteur (8101) reliant électriquement le premier élément (C1) ;
une deuxième zone (812) comportant une seconde extrémité de connecteur (8102) reliant électriquement le deuxième élément (C2), la deuxième zone (812) étant disposée à travers la partie de charnière (H) ;
une troisième zone (813) disposée entre la première zone (811) et la deuxième zone (812), la troisième zone (813) comprenant une première partie (8131) s'étendant dans une première direction et une seconde partie (8132) s'étendant dans une seconde direction à la deuxième zone (812), la seconde direction étant différente de la première direction, dans lequel la première zone (811) et la troisième zone (813) sont disposées dans le premier boîtier (21) ;
**caractérisé en ce que**,
la carte de circuit imprimé flexible (81) comprend en outre une quatrième zone (814) espacée de la deuxième zone (812) et s'étendant à partir de la première zone (811) ou de la troisième zone (813) vers la partie de charnière (H), la quatrième zone (814) comportant une partie rigide (F3) reliée au premier boîtier (21).

2. Dispositif électronique pliable selon la revendication 1, dans lequel au moins une ligne de signal comprise dans la carte de circuit imprimé flexible (81) n'est pas disposée dans la partie rigide (F3).

3. Dispositif électronique pliable selon la revendication 1 ou 2, dans lequel le premier boîtier (21) comprend une première zone de soutien (411A), une troisième zone de soutien (411B) prévue opposée à la première zone de soutien (411A) et une première ouverture (401) configurée pour pénétrer la première zone de soutien (411A) et la troisième zone de soutien (411B),
dans lequel le second boîtier (22) comprend une deuxième zone de soutien (421A), une quatrième zone de soutien (421B) prévue opposée à la deuxième zone de soutien (421A), et une deuxième ouverture (402) configurée pour pénétrer la deuxième zone de soutien (421A) et la quatrième zone de soutien (421B),
dans lequel, à un état plié du boîtier pliable (20), la première zone de soutien (411A) et la deuxième zone de soutien (421A) font face l'une à l'autre et la troisième zone de soutien (411B) et la quatrième zone de soutien (421B) sont orientées dans des directions opposées l'une à l'autre,
dans lequel le premier élément (C1) est disposé sur la troisième zone de soutien (411B) et le deuxième élément (C2) est disposé sur la quatrième zone de soutien (421B),
dans lequel la deuxième zone (812) de la carte de circuit imprimé flexible (81) pénètre la première ouverture (401) et la deuxième ouverture (402), et
dans lequel la partie rigide (F3) est fixée à la troisième zone de soutien (411B).

4. Dispositif électronique pliable selon la revendication 3, dans lequel le dispositif électronique pliable (2) comprend en outre un premier membre d'étanchéité (91) disposé dans la première ouverture (401) et un second membre d'étanchéité (92) disposé dans la deuxième ouverture (402),
dans lequel la deuxième zone (812) de la carte de circuit imprimé flexible (81) est fixée au premier boîtier (21) via le premier membre d'étanchéité (91),
dans lequel la deuxième zone (812) de la carte de circuit imprimé flexible (81) est fixée au second boîtier (22) via le second membre d'étanchéité (92), et
dans lequel la partie rigide (F3) et la première ouverture (401) sont disposées dans une direction d'un axe de pliage (A) du dispositif électronique pliable.

5. Dispositif électronique pliable selon la revendication 3 ou 4, comprend en outre une batterie (1110) disposée sur la troisième zone de soutien (411B),
dans lequel la troisième zone (813) de la carte de circuit imprimé flexible (81) chevauche la batterie (1110), et
dans lequel la partie rigide (F3) est disposée sur une zone de fixation entre la batterie (1110) et le second boîtier (22) en référence à un état déplié du dispositif électronique pliable.

6. Dispositif électronique pliable selon l'une quelconque des revendications 3 à 5, comprend en outre une autre carte de circuit imprimé flexible (82) reliant électriquement un troisième élément (C3) disposé dans le premier boîtier (21) et un quatrième élément (C4) disposé dans le second boîtier (22), l'autre carte de circuit imprimé flexible (82) étant disposée à travers la partie de charnière (H),
dans lequel le premier boîtier (21) comporte une troisième ouverture (403) configurée pour pénétrer la première zone de soutien (411A) et la troisième zone de soutien (411B),
dans lequel le second boîtier (22) comporte une quatrième ouverture (404) configurée pour pénétrer la deuxième zone de soutien (421A) et la quatrième zone de soutien (421B),
dans lequel l'autre carte de circuit imprimé flexible (82) pénètre la troisième ouverture (403) et la quatrième ouverture (404), et
dans lequel la partie rigide (F3) est fixée sur une zone de fixation de la troisième zone de soutien (411B) située entre la première ouverture (401) et la troisième ouverture (403).

7. Dispositif électronique pliable selon l'une quelconque des revendications 1 à 6,
dans lequel la carte de circuit imprimé flexible (81) comporte un premier bord (81C) et un second bord (81D), la carte de circuit imprimé flexible (81) ayant une largeur entre le premier bord (81C) et le second bord (81D),
dans lequel le premier bord (81C) est plus proche de la partie rigide (F3) que le second bord (81D), et
dans lequel la carte de circuit imprimé flexible (81) comprend en outre une première encoche (N1) prévue dans la troisième zone (813), la première encoche (N1) formée au premier bord (81C).

8. Dispositif électronique pliable selon la revendication 7, dans lequel la carte de circuit imprimé flexible (81) comprend en outre une seconde encoche (N2) prévue dans la première zone (811), la seconde encoche (N2) formée au second bord (81D).

9. Dispositif électronique pliable selon l'une quelconque des revendications 1 à 8, dans lequel la partie rigide (F3) de la carte de circuit imprimé flexible (81) comprend en outre une ou plusieurs ouvertures (818, 819), et le premier boîtier (21) comprend une ou plusieurs saillies (P1, P2) insérées à l'intérieur de l'une ou plusieurs ouvertures (818, 819).

10. Dispositif électronique pliable selon l'une quelconque des revendications 1 à 9,
dans lequel la partie rigide (F3) comporte une partie de renforcement.

11. Dispositif électronique pliable selon l'une quelconque des revendications 1 à 9, dans lequel la partie rigide (F3) est reliée à la première zone (811) ou à la troisième zone (813) via un membre de connexion (1200).

12. Dispositif électronique pliable selon l'une quelconque des revendications 1 à 11, dans lequel la troisième zone (813) de la carte de circuit imprimé flexible (81) est prévue sous la forme d'un coude de 90 degrés.

13. Dispositif électronique pliable selon l'une quelconque des revendications 1 à 12, dans lequel la deuxième zone (812) de la carte de circuit imprimé flexible (81) comprend en outre une première partie de fixation (F1) couplée à la partie de charnière (H) correspondant au premier boîtier (21) et une seconde partie de fixation (F2) couplée à la partie de charnière (H) correspondant au second boîtier (22), et dans lequel la première partie de fixation (F1) et/ou la seconde partie de fixation (F2) sont rigides.

14. Dispositif électronique pliable selon la revendication 13, dans lequel la partie de charnière (H) comprend un module de charnière (5A), et une première plaque (71) et une seconde plaque (72) couplées au module de charnière (5A),
dans lequel le module de charnière (5A) comprend un premier support (51A) fixé au premier boîtier (21), un second support (52A) fixé au second boîtier (22), et un connecteur de support configuré (53A) pour relier le premier support (51A) et le second support (52A),
dans lequel la première plaque (71) est couplée au connecteur de support (53A) configuré correspondant au premier boîtier (21) et la seconde plaque (72) est couplée au connecteur de support configuré (53A) correspondant au second boîtier (22),
dans lequel une première surface (71A) de la première plaque (71) et une seconde surface (72A) de la seconde plaque (72) se font face à l'état plié du boîtier pliable (20),
dans lequel un angle formé par la première surface (71A) et la seconde surface (72A) à un état déplié du boîtier pliable (20) est de 180 degrés,
dans lequel la première partie de fixation (F1) de la carte de circuit imprimé flexible (81) **est couplée** à la première plaque (71), et
dans lequel la seconde partie de fixation (F2) de la carte de circuit imprimé flexible (81) est couplée à la seconde plaque (72).

15. Dispositif électronique pliable selon l'une quelconque des revendications 1 à 14, comprenant en outre un module d'affichage flexible (24) disposé dans le boîtier pliable (20),
dans lequel le module d'affichage flexible (24) comprend :
une première zone d'affichage (①) disposée dans le premier boîtier (21) ;
une deuxième zone d'affichage (②) disposée dans le second boîtier (22) ; et
une troisième zone d'affichage (③) positionnée correspondant à la partie de charnière (H) et étendant la première zone d'affichage (①) et la deuxième zone d'affichage (②).
